(19)

**Europäisches Patentamt**
**European Patent Office**
**Office européen des brevets**

(11) **EP 3 941 033 A1**

(12) **EUROPEAN PATENT APPLICATION**
published in accordance with Art. 153(4) EPC

(43) Date of publication:
**19.01.2022 Bulletin 2022/03**

(21) Application number: **19918796.4**

(22) Date of filing: **28.11.2019**

(51) International Patent Classification (IPC):
**H04N 5/374** (2011.01)     **H01L 27/146** (2006.01)

(52) Cooperative Patent Classification (CPC):
**H01L 27/146; H04N 5/374**

(86) International application number:
**PCT/JP2019/046497**

(87) International publication number:
**WO 2020/183809 (17.09.2020 Gazette 2020/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **13.03.2019 JP 2019045436**
**16.08.2019 JP 2019149226**

(71) Applicant: **Sony Semiconductor Solutions Corporation**
**Atsugi-shi Kanagawa 243-0014 (JP)**

(72) Inventors:
• **SATO, Mamoru**
  **Atsugi-shi, Kanagawa 243-0014 (JP)**
• **KATO, Akihiko**
  **Atsugi-shi, Kanagawa 243-0014 (JP)**
• **OIKE, Yusuke**
  **Atsugi-shi, Kanagawa 243-0014 (JP)**
• **HARATA, Hidehiro**
  **Atsugi-shi, 243-0014 (JP)**
• **NAGANUMA, Hideki**
  **Atsugi-shi, Kanagawa 243-0014 (JP)**

(74) Representative: **Müller Hoffmann & Partner Patentanwälte mbB**
**St.-Martin-Strasse 58**
**81541 München (DE)**

(54) **SOLID-STATE IMAGING DEVICE, ELECTRONIC APPARATUS, AND METHOD FOR CONTROLLING SOLID-STATE IMAGING DEVICE**

(57)     To improve charge transfer efficiency in a solid-state imaging device that transfers a charge from a photoelectric conversion element to a floating diffusion layer.

A solid-state imaging device is provided with a transfer transistor and a potential control unit. In this solid-state imaging device, the transfer transistor transfers a charge from a photoelectric conversion element to a floating diffusion layer in a predetermined transfer period according to a transfer signal transmitted through a predetermined transfer line. Furthermore, the potential control unit makes a potential in a transfer period of a predetermined signal line capacitively coupled with the floating diffusion layer higher than that outside the transfer period.

FIG. 6

EP 3 941 033 A1

**Description**

TECHNICAL FIELD

The present technology relates to a solid-state imaging device, an electronic device, and a control method of a solid-state imaging device. Specifically, this relates to a solid-state imaging device that performs differential amplification, an imaging device, and a control method of a solid-state imaging device.

BACKGROUND ART

Conventionally, a differential amplification solid-state imaging device that performs differential amplification has been used in an imaging device. For example, a solid-state imaging device has been proposed in which one of a pair of pixels is a reference pixel, the other is a read pixel, and a current mirror circuit and a current source are connected to these pixels (refer to, for example, Patent Document 1). In this solid-state imaging device, a photoelectric conversion element, a transfer transistor, and a floating diffusion layer are provided in the read pixel, and among them, the transfer transistor transfers a charge from the photoelectric conversion element to the floating diffusion layer.

CITATION LIST

PATENT DOCUMENT

Patent Document 1: Japanese Patent Application Laid-Open No. 2018-182496

SUMMARY OF THE INVENTION

PROBLEMS TO BE SOLVED BY THE INVENTION

In the above-described conventional technology, a reference pixel, a read pixel, a current mirror circuit, and a current source form a differential amplifier circuit, and the differential amplifier circuit performs differential amplification, thereby improving a gain for amplifying a signal. However, it is difficult to further improve charge transfer efficiency from the photoelectric conversion element to the floating diffusion layer. As an amplitude of a transfer signal supplied to the transfer transistor increases, the transfer efficiency may be improved, but this is not preferable because power consumption increases.
The present technology is achieved in view of such a situation, and an object thereof is to improve charge transfer efficiency in a solid-state imaging device that transfers a charge from a photoelectric conversion element to a floating diffusion layer.

SOLUTIONS TO PROBLEMS

The present technology is achieved for solving the above-described problem, and a first aspect thereof is a solid-state imaging device provided with a transfer transistor that transfers a charge from a photoelectric conversion element to a floating diffusion layer in a predetermined transfer period according to a transfer signal transmitted through a predetermined transfer line, and a potential control unit that makes a potential in the transfer period of a predetermined signal line capacitively coupled to the floating diffusion layer higher than the potential outside the transfer period, and a control method thereof. This brings about an effect that a voltage increase amount of the floating diffusion layer in the transfer period increases.
Furthermore, in the first aspect, the transfer transistor may include a reference side transfer transistor arranged in a reference pixel and a read side transfer transistor arranged in a read pixel, and the reference pixel may be further provided with a reference side reset transistor that initializes the floating diffusion layer in the reference pixel according to a predetermined reset signal, a reference side amplification transistor that amplifies a voltage of the floating diffusion layer in the reference pixel, and a reference side selection transistor that outputs a signal corresponding to the voltage amplified by the reference side amplification transistor according to a predetermined selection signal, and the read pixel may be further provided with a read side reset transistor that initializes the floating diffusion layer in the read pixel according to a predetermined reset signal, a read side amplification transistor that amplifies a voltage of the floating diffusion layer in the read pixel, and a read side selection transistor that outputs a signal corresponding to the voltage amplified by the read side amplification transistor according to a predetermined selection signal. This brings about an effect that the voltage increase amount of the floating diffusion layer increases in a differential amplification solid-state imaging device.

Furthermore, in the first aspect, a tail current source that supplies a current to a vertical current supply line commonly connected to the reference side amplification transistor and the read side amplification transistor may be further provided, in which the predetermined signal line may include the vertical current supply line. This brings about an effect that the voltage increase amount of the floating diffusion layer increases by an amount corresponding to a parasitic capacitance of the vertical current supply line.

Furthermore, in the first aspect, the potential control unit may be provided with a switch that makes a potential of the vertical current supply line in the transfer period higher than the potential outside the transfer period. This brings about an effect that the voltage increase amount of the floating diffusion layer increases by an amount corresponding to a parasitic capacitance of the vertical current supply line.

Furthermore, in the first aspect, the read side selection transistor may output the signal through a vertical signal line, and the potential control unit may be provided with a switch that connects the vertical current supply line to the vertical signal line in the transfer period. This brings about an effect that the voltage increase amount of the floating diffusion layer increases by an amount corresponding to a parasitic capacitance of the vertical current supply line.

Furthermore, in the first aspect, the predetermined signal line may include a vertical signal line that transmits the signal from the read side selection transistor, and the potential control unit may be provided with a switch that makes a potential of the vertical signal line in the transfer period higher than the potential outside the transfer period. This brings about an effect that the voltage increase amount of the floating diffusion layer increases by an amount corresponding to a parasitic capacitance of the vertical signal line.

Furthermore, in the first aspect, the predetermined signal line may include a potential fluctuation dedicated line, and the potential control unit may be provided with a driver that makes a potential of the potential fluctuation dedicated line in the transfer period higher than the potential outside the transfer period. This brings about an effect that the voltage increase amount of the floating diffusion layer increases by an amount corresponding to a parasitic capacitance of the potential fluctuation dedicated line.

Furthermore, in the first aspect, the potential fluctuation dedicated line may be wired in a horizontal direction. This brings about an effect that the voltage increase amount of the floating diffusion layer increases by an amount corresponding to a parasitic capacitance of the potential fluctuation dedicated line in the horizontal direction.

Furthermore, in the first aspect, the potential fluctuation dedicated line may be wired in a vertical direction. This brings about an effect that the voltage increase amount of the floating diffusion layer increases by an amount corresponding to a parasitic capacitance of the potential fluctuation dedicated line in the vertical direction.

Furthermore, in the first aspect, the read pixel may be further provided with a conversion efficiency control transistor that controls conversion efficiency of conversion of the charge into the voltage, and the predetermined signal line may include a control line connected to a gate of the conversion efficiency control transistor. This brings about an effect that the voltage increase amount of the floating diffusion layer increases by an amount corresponding to a parasitic capacitance of the control line.

Furthermore, in the first aspect, an amplitude of the reset signal to the read side reset transistor and an amplitude of the reset signal to the reference side reset transistor may be different from each other. This brings about an effect that the amplitude of the vertical signal line is expanded.

Furthermore, in the first aspect, a driver that controls a potential of the transfer signal to any one of a predetermined low level, a middle level higher than the low level, and a high level higher than the middle level may be further provided, in which the driver may cause transition of the potential of the transfer signal from the high level to the middle level in the transfer period. This brings about an effect that a phenomenon that a part of the charge returns to the photoelectric conversion element is suppressed.

Furthermore, in the first aspect, a current amount control unit that increases a current amount of a tail current supplied to the reference side amplification transistor and the read side amplification transistor over a predetermined period from when the transfer period ends may be further provided. This brings about an effect that a settling time is shortened.

Furthermore, in the first aspect, a wiring layer may be arranged between a microlens and the photoelectric conversion element on a predetermined semiconductor substrate, and the transfer transistor may be arranged in the wiring layer. This brings about an effect that a voltage increase amount of the floating diffusion layer increases in a front surface irradiation solid-state imaging device.

Furthermore, in the first aspect, the photoelectric conversion element may be arranged between a microlens and a wiring layer on a predetermined semiconductor substrate, and the transfer transistor may be arranged in the wiring layer. This brings about an effect that a voltage increase amount of the floating diffusion layer increases in a back surface irradiation solid-state imaging device.

Furthermore, a second aspect of the present technology is an electronic device provided with a reference pixel provided with a predetermined wire, and a read pixel provided with a wire having a shape different from a shape of the wire of the reference pixel. This brings about an effect that different parasitic capacitances are generated in a wire on a reference side and a wire on a read side.

Furthermore, in the second aspect, in a horizontal direction perpendicular to a vertical signal line in a predetermined wiring layer, a length of a portion where a wire connected to a reference side reset transistor in the reference pixel and a wire that connects a reference side amplification transistor to a reference side floating diffusion layer are closest may be shorter than a length of a portion where a wire connected to a read side reset transistor in the read pixel and a wire that connects a read side amplification transistor to a read side floating diffusion layer are closest. This brings about an effect that a parasitic capacitance different from that on the read side is generated between the wire connected to the reset transistor on the reference side and the floating diffusion layer.

Furthermore, a third aspect of the present technology is a solid-state imaging device provided with a read side photoelectric conversion element connected to a predetermined negative potential lower than a predetermined ground potential, a read side transfer transistor that transfers a charge from the read side photoelectric conversion element to a read side floating diffusion layer, a reference side photoelectric conversion element connected to the negative potential, a reference side transfer transistor that transfers a charge from the reference side photoelectric conversion element to a reference side floating diffusion layer, and a column read circuit unit provided with a tail current source connected to the ground potential that outputs, as a pixel signal, a signal obtained by amplifying a difference between a voltage of the read side floating diffusion layer and a voltage of the reference side floating diffusion layer. This brings about an effect that charge transfer efficiency is improved.

Furthermore, in the third aspect, the column read circuit unit may be further provided with a negative potential generation unit that generates the negative potential. This brings about an effect that external power supply types and terminals of a CMOS image sensor 10 are reduced.

Furthermore, in the third aspect, the column read circuit unit may be further provided with a switch that supplies either the negative potential or the ground potential to the read side photoelectric conversion element and the reference side photoelectric conversion element, and the column read circuit unit may amplify the difference in a case where a predetermined differential mode is set, and output each of a signal obtained by amplifying the voltage of the read side floating diffusion layer and a signal obtained by amplifying the voltage of the reference side floating diffusion layer in a case where a predetermined source follower mode is set, and the switch may supply the negative potential in a case where the differential mode is set, and supply the ground potential in a case where the source follower mode is set. This brings about an effect that the transfer efficiency is improved in the differential mode.

Furthermore, in the third aspect, a vertical drive unit that supplies a transfer signal to each of the read side transfer transistor and the reference side transfer transistor may be further provided, in which the vertical drive unit may supply the transfer signal at a lower level than a level in the source follower mode in a case where the differential mode is set. This brings about an effect that a breakdown voltage of a gate oxide film of a transistor corresponding to the transfer signal may be made similar to that in an SF mode to avoid an influence on reliability.

Furthermore, in the third aspect, the column read circuit unit may output a signal obtained by amplifying the difference through a vertical signal line, and a shield line that covers the vertical signal line may be connected to the ground potential. This brings about an effect of reducing noise.

Furthermore, a fourth aspect of the present technology is an imaging device provided with a transfer transistor that transfers a charge from a photoelectric conversion element to a floating diffusion layer in a predetermined transfer period according to a transfer signal transmitted through a predetermined transfer line, a potential control unit that makes a potential in the transfer period of a predetermined signal line capacitively coupled to the floating diffusion layer higher than the potential outside the transfer period, and a signal processing unit that processes a pixel signal corresponding to a voltage of the floating diffusion layer. This brings about an effect that the voltage increase amount of the floating diffusion layer in the transfer period increases, and the pixel signal corresponding to the voltage of the floating diffusion layer is processed.

BRIEF DESCRIPTION OF DRAWINGS

Fig. 1 is a block diagram illustrating a configuration example of a solid-state imaging device according to a first embodiment of the present technology.

Fig. 2 is an example of a plan view of a pixel array unit according to the first embodiment of the present technology.

Fig. 3 is a circuit diagram illustrating a configuration example of a reference pixel and a read pixel according to the first embodiment of the present technology.

Fig. 4 is a circuit diagram illustrating an example of a parasitic capacitance in the read pixel according to the first embodiment of the present technology.

Fig. 5 is a block diagram illustrating a configuration example of a column read circuit unit according to the first embodiment of the present technology.

Fig. 6 is a circuit diagram illustrating a configuration example of a unit read circuit, the reference pixel, and the read pixel according to the first embodiment of the present technology.

Fig. 7 is a timing chart illustrating an example of a read operation of a complementary metal oxide semiconductor (CMOS) image sensor according to the first embodiment of the present technology.

Fig. 8 is a flow chart illustrating an example of an operation of the CMOS image sensor according to the first embodiment of the present technology.

Fig. 9 is an example of a cross-sectional view of the CMOS image sensor according to the first embodiment of the present technology.

Fig. 10 is a circuit diagram illustrating a configuration example of a unit read circuit, a reference pixel, and a read pixel according to a second embodiment of the present technology.

Fig. 11 is a timing chart illustrating an example of a read operation of a CMOS image sensor according to the second embodiment of the present technology.

Fig. 12 is a circuit diagram illustrating a configuration example of a unit read circuit, a reference pixel, and a read pixel according to a third embodiment of the present technology.

Fig. 13 is a timing chart illustrating an example of a read operation of a CMOS image sensor according to the third embodiment of the present technology.

Fig. 14 is a block diagram illustrating a configuration example of a vertical drive unit according to a fourth embodiment of the present technology.

Fig. 15 is a timing chart illustrating an example of a read operation of a CMOS image sensor according to the fourth embodiment of the present technology.

Fig. 16 is a plan view illustrating a layout example of a reference pixel according to the fourth embodiment of the present technology.

Fig. 17 is a plan view illustrating a layout example of a read pixel according to the fourth embodiment of the present technology.

Fig. 18 is a block diagram illustrating a configuration example of a vertical drive unit according to a fifth embodiment of the present technology.

Fig. 19 is a circuit diagram illustrating a configuration example of a unit read circuit, a reference pixel, and a read pixel according to the fifth embodiment of the present technology.

Fig. 20 is a circuit diagram illustrating an example of a parasitic capacitance in the read pixel according to the fifth embodiment of the present technology.

Fig. 21 is a circuit diagram illustrating an example of a parasitic capacitance in the reference pixel according to the fifth embodiment of the present technology.

Fig. 22 is a timing chart illustrating an example of a read operation of a CMOS image sensor according to the fifth embodiment of the present technology.

Fig. 23 is a circuit diagram illustrating a configuration example of a unit read circuit, a reference pixel, and a read pixel according to a sixth embodiment of the present technology.

Fig. 24 is a circuit diagram illustrating an example of a parasitic capacitance in the read pixel according to the sixth embodiment of the present technology.

Fig. 25 is a circuit diagram illustrating an example of a parasitic capacitance in the reference pixel according to the sixth embodiment of the present technology.

Fig. 26 is a timing chart illustrating an example of a read operation of a CMOS image sensor according to the sixth embodiment of the present technology.

Fig. 27 is a block diagram illustrating a configuration example of a vertical drive unit according to a seventh embodiment of the present technology.

Fig. 28 is a circuit diagram illustrating a configuration example of a reference pixel and a read pixel according to the seventh embodiment of the present technology.

Fig. 29 is a circuit diagram illustrating an example of a parasitic capacitance in the read pixel according to the seventh embodiment of the present technology.

Fig. 30 is a timing chart illustrating an example of a read operation of a CMOS image sensor according to the seventh embodiment of the present technology.

Fig. 31 is an example of a cross-sectional view of the CMOS image sensor according to an eighth embodiment of the present technology.

Fig. 32 is a circuit diagram illustrating a configuration example of a unit read circuit according to a ninth embodiment of the present technology.

Fig. 33 is a timing chart illustrating an example of a read operation of a CMOS image sensor according to the ninth embodiment of the present technology.

Fig. 34 is a circuit diagram illustrating a configuration example of a reference pixel and a read pixel according to the tenth embodiment of the present technology.

Fig. 35 is an example of a cross-sectional view of the CMOS image sensor according to the tenth embodiment of the present technology.

Fig. 36 is a circuit diagram illustrating a configuration example of a column read circuit unit, a reference pixel, and a read pixel according to an eleventh embodiment of the present technology.

Fig. 37 is a circuit diagram illustrating a configuration example of a column read circuit unit, a reference pixel, and a read pixel according to a twelfth embodiment of the present technology.

Fig. 38 is a view illustrating a set example of a level of a transfer signal according to the twelfth embodiment of the present technology.

Fig. 39 is a circuit diagram illustrating a configuration example of a pixel array unit according to the tenth embodiment of the present technology.

Fig. 40 is a view illustrating a configuration example of a stacked solid-state imaging device to which the present technology is applicable.

Fig. 41 is a block diagram illustrating a configuration example of an electronic device including a solid-state imaging device to which the present technology is applied.

Fig. 42 is a view illustrating a usage example of a solid-state imaging device to which the present technology is applied.

Fig. 43 is a block diagram illustrating a schematic configuration example of a vehicle control system.

Fig. 44 is an illustrative view illustrating an example of installation positions of a vehicle exterior information detection unit and an imaging unit.

MODE FOR CARRYING OUT THE INVENTION

A mode for carrying out the present technology (hereinafter, referred to as an embodiment) is hereinafter described. The description is given in the following order.

1. First Embodiment (Example of increasing potential of vertical current supply line)
2. Second Embodiment (Example of connecting vertical current supply line to vertical signal line and increasing potential thereof)
3. Third Embodiment (Example of increasing potential of vertical signal line)
4. Fourth Embodiment (Example of increasing potential of vertical current supply line and performing three-value control of transfer signal)
5. Fifth Embodiment (Example of increasing potential of potential fluctuation line in horizontal direction)
6. Sixth Embodiment (Example of increasing potential of potential fluctuation line in vertical direction)
7. Seventh Embodiment (Example of increasing potential of vertical current supply line and controlling charge-voltage conversion efficiency)
8. Eighth Embodiment (Example of increasing potential of vertical current supply line in back surface irradiation type)
9. Ninth Embodiment (Example of increasing potential of vertical current supply line and increasing tail current)
10. Variation
11. Configuration of Electronic Device
12. Usage Example of Solid-State Imaging Device
13. Application Example to Mobile Body

<1. First Embodiment>

[Configuration example of solid-state imaging device]

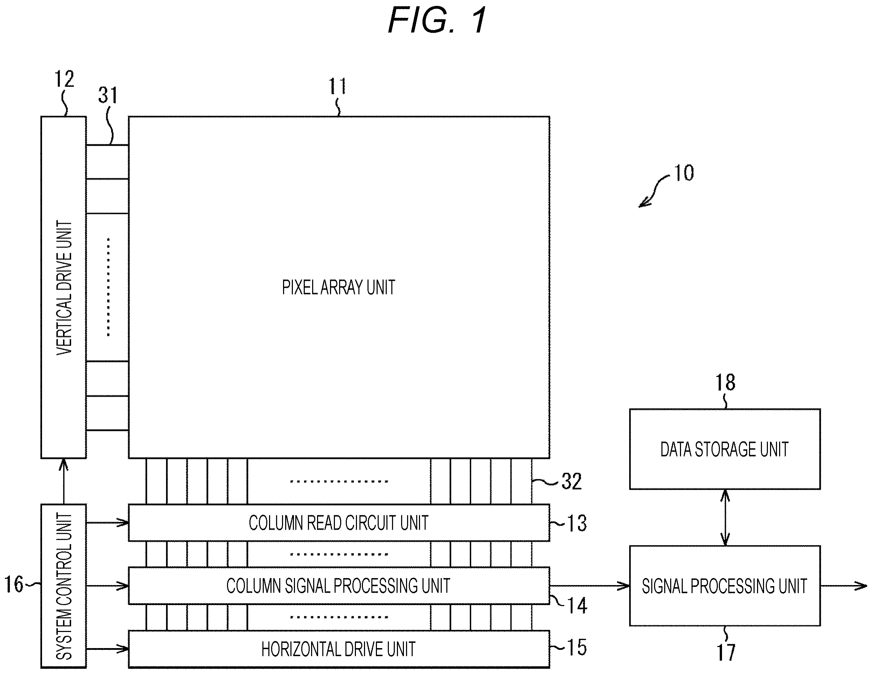

Fig. 1 is a view illustrating a configuration example of one embodiment of a solid-state imaging device to which the present technology is applied.

A CMOS image sensor 10 in Fig. 1 is an example of a solid-state imaging device using a CMOS. The CMOS image sensor 10 takes in incident light (image light) from a subject through an optical lens system (not illustrated) and converts a light amount of the incident light an image of which is formed on an imaging surface to an electric signal in a pixel unit to output as a pixel signal. Note that the CMOS image sensor 10 is an example of a solid-state imaging device recited in claims.

In Fig. 1, the CMOS image sensor 10 includes a pixel array unit 11, a vertical drive unit 12, a column read circuit unit 13, a column signal processing unit 14, a horizontal drive unit 15, a system control unit 16, a signal processing unit 17, and a data storage unit 18.

The pixel array unit 11, the vertical drive unit 12, the column read circuit unit 13, the column signal processing unit 14, the horizontal drive unit 15, the system control unit 16, the signal processing unit 17, and the data storage unit 18 are formed on the same or a plurality of electrically connected stacked semiconductor substrates (chips).

In the pixel array unit 11, unit pixels (pixels) each including a photoelectric conversion unit (for example, a photodiode) capable of photoelectrically converting a charge amount corresponding to an incident light amount, accumulating the same therein, and outputting the same as a signal is two-dimensionally arranged in a matrix.

Note that there is a case where the pixel array unit 11 includes a region in which, in addition to effective pixels (effective pixels), dummy pixels each having a structure without a photodiode that performs photoelectric conversion, and light-shielding pixels equivalent to the effective pixels except that a light-receiving surface is light-shielded and external light incidence is blocked are two-dimensionally arranged in a matrix.

Furthermore, in the following description, there is a case where an optical charge of the charge amount corresponding to the incident light amount is simply referred to as the "charge", and the unit pixel is simply referred to as the "pixel".

In the pixel array unit 11, moreover, for a pixel array in a matrix, a pixel drive line 31 is formed in a right-to-left direction in the drawing (in a pixel array direction of a pixel row) for each row, and a vertical pixel wire 32 is formed in a top-to-bottom direction in the drawing (in a pixel array direction of a pixel column) for each column. One end of the pixel drive line 31 is connected to an output end corresponding to each row of the vertical drive unit 12.

The column read circuit unit 13 at least includes a circuit that supplies a constant current to pixels of a selected row in the pixel array unit 11 for each column, a current mirror circuit that forms a high gain amplifier, and a read mode changeover switch, forms an amplifier together with a transistor in the selected pixel in the pixel array unit 11, converts an optical charge signal into a voltage signal, and outputs the same to the vertical pixel wire 32.

The vertical drive unit 12 is a pixel drive unit including a shift register, an address decoder and the like that drives the pixels of the pixel array unit 11 all at once, row by row or the like. Although a specific configuration of the vertical drive unit 12 is not illustrated, this includes a read scan system and a sweep scan system, or batch sweeping and batch transfer.

The read scan system sequentially selectively scans the pixels of the pixel array unit 11 row by row in order to read signals from the pixels. In a case of row drive (rolling shutter operation), as for sweeping, sweep scanning is performed on a read row on which read scanning is performed by the read scan system prior to the read scanning by a time corresponding to a shutter speed.

Furthermore, in a case of global exposure (global shutter operation), the batch sweeping is performed prior to the batch transfer by a time corresponding to a shutter speed. By this sweeping, an unnecessary charge is swept (reset) from the photoelectric conversion element of the pixel of the read row. Then, a so-called electronic shutter operation is performed by sweeping (resetting) the unnecessary charge.

Here, the electronic shutter operation is intended to mean an operation of sweeping an unnecessary optical charge accumulated in the photoelectric conversion element until immediately before and newly starting exposing (starting accumulating the optical charge). The signal read by a read operation by the read scan system corresponds to an amount of light incident after the read operation immediately before the same or electronic shutter operation.

In a case of row drive, a period from a read timing by the read operation immediately before or a sweep timing by the electronic shutter operation to a read timing by the current read operation is an optical charge accumulation time (exposure time) in the pixel. In a case of the global exposure, a time from the batch sweeping to the batch transfer is the accumulation time (exposure time).

The pixel signals output from the pixels of the pixel row selectively scanned by the vertical drive unit 12 are supplied to the column signal processing unit 14 through the vertical pixel wires 32, respectively. The column signal processing unit 14 performs predetermined signal processing on the pixel signal output from each pixel of the selected row through the vertical pixel wire 32 for each pixel column of the pixel array unit 11, and temporarily holds the pixel signal after the signal processing.

Specifically, the column signal processing unit 14 performs, as the signal processing, at least noise removal processing, for example, correlated double sampling (CDS) processing. By the correlated double sampling by the column signal processing unit 14, fixed pattern noise unique to the pixel such as reset noise and threshold variation of an amplification transistor is removed. Note that it is also possible to provide an analog-digital (AD) conversion function, for example, in addition to the noise removal processing to the column signal processing unit 14 and output a signal level as a digital signal.

The horizontal drive unit 15 includes a shift register, an address decoder and the like, and sequentially selects a unit circuit corresponding to the pixel column of the column signal processing unit 14. According to selective scanning by the horizontal drive unit 15, the pixel signals subjected to the signal processing by the column signal processing unit 14 are sequentially output to the signal processing unit 17.

The system control unit 16 includes a timing generator that generates various timing signals and the like, and performs drive control of the vertical drive unit 12, the column signal processing unit 14, the horizontal drive unit 15 and the like on the basis of various timing signals generated by the timing generator.

The CMOS image sensor 10 is further provided with the signal processing unit 17 and the data storage unit 18. The signal processing unit 17 at least has an addition processing function and performs various types of signal processing such as addition processing on the pixel signal output from the column signal processing unit 14. The data storage unit 18 temporarily stores data required for the signal processing in the signal processing unit 17.

The signal processing unit 17 and the data storage unit 18 may be an external signal processing unit provided on a substrate different from that of the CMOS image sensor 10, for example, processing by a digital signal processor (DSP) or software, or they may be mounted on the same substrate as that of the CMOS image sensor 10.

[Configuration example of pixel array unit]

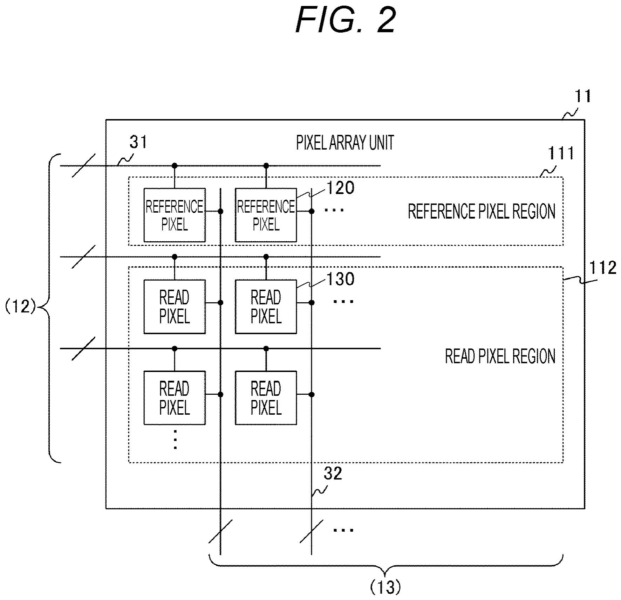

Fig. 2 is an example of a plan view of the pixel array unit 11 according to a first embodiment of the present technology. The pixel array unit 11 is provided with a reference pixel region 111 and a read pixel region 112. In the reference pixel region 111, a plurality of reference pixels 120 is arrayed in a horizontal direction. In contrast, in the read pixel region 112, a plurality of read pixels 130 is arrayed in a two-dimensional lattice pattern. Here, the read pixel 130 is a pixel from which the pixel signal is to be read. In contrast, the reference pixel 120 is a pixel that outputs a reference signal to be compared with the signal from the read pixel 130 at the time of differential amplification.

Hereinafter, a set of pixels (reference pixels 120 and read pixels 130) arrayed in the horizontal direction is referred to as a "row", and a set of pixels arrayed in a direction perpendicular to the row is referred to as a "column".

Each of the pixels in the row is connected to the vertical drive unit 12 through the pixel drive line 31. Furthermore, each of the pixels in the column is connected to the column read circuit unit 13 through the vertical pixel wire 32.

[Configuration example of pixel]

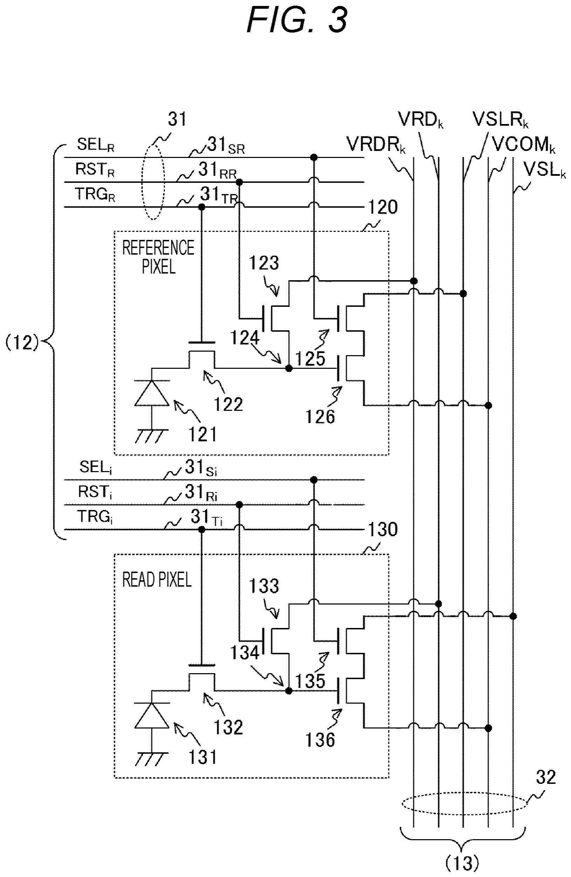

Fig. 3 is a circuit diagram illustrating a configuration example of the reference pixel 120 and the read pixel 130 according to the first embodiment of the present technology. The reference pixel 120 is provided with a photoelectric conversion element 121, a transfer transistor 122, a reset transistor 123, a floating diffusion layer 124, a selection transistor 125, and an amplification transistor 126. Furthermore, the read pixel 130 is provided with a photoelectric conversion element 131, a transfer transistor 132, a reset transistor 133, a floating diffusion layer 134, a selection transistor 135, and an amplification transistor 136.

Furthermore, a selection line $31_{SR}$, a reset line $31_{RR}$, and a transfer line $31_{TR}$ are wired in the row of the reference pixel 120. When the number of rows in the read pixel region 112 is set to I (I is an integer), a selection line $31_{Si}$, a reset line $31_{Ri}$, and a transfer line $31_{Ti}$ are wired to an i-th (i is an integer from 0 to I-1) row. When the number of columns is set to K (K is an integer), vertical reset input lines $VRDR_k$ and $VRD_k$, vertical signal lines $VSLR_k$ and $VSL_k$, and a vertical current supply line $VCOM_k$ are wired to a k-th (k is an integer from 0 to K-1) column.

The photoelectric conversion element 121 generates the charge by the photoelectric conversion. The transfer transistor 122 transfers the charge from the photoelectric conversion element 121 to the floating diffusion layer 124 according to a transfer signal $TRG_R$ transferred through the transfer line $31_{TR}$.

The reset transistor 123 connects the floating diffusion layer 124 to the vertical reset input line $VRDR_k$ according to a reset signal $RST_R$ transmitted through the reset line $31_{RR}$, extracts the charge of the floating diffusion layer 124, and initializes a voltage thereof.

The floating diffusion layer 124 accumulates the transferred charge and generates the voltage corresponding to the charge amount.

The amplification transistor 126 amplifies the voltage of the floating diffusion layer 124. A source of the amplification transistor 126 is connected to the vertical current supply line $VCOM_k$.

The selection transistor 125 outputs a signal corresponding to the amplified voltage to the vertical signal line $VSLR_k$ according to a selection signal $SEL_R$ transmitted through the selection line $31_{SR}$.

A circuit configuration of the read pixel 130 is similar to that of the reference pixel 120. However, a transfer signal $TRG_i$ is transmitted through the transfer line $31_{Ti}$, and a reset signal $RST_i$ is transmitted through the reset line $31_{Ri}$. A selection signal $SEL_i$ is transmitted through the selection line $31_{Si}$. Furthermore, the reset transistor 133 connects the floating diffusion layer 134 to the vertical reset input line $VRD_k$, and the selection transistor 135 outputs a signal to the vertical signal line $VSL_k$. A source of the amplification transistor 136 is connected to the vertical current supply line $VCOM_k$.

Note that the transfer transistor 122 is an example of a reference side transfer transistor recited in claims, and the transfer transistor 132 is an example of a read side transfer transistor recited in claims. The reset transistor 123 is an example of a reference side reset transistor recited in claims, and the reset transistor 133 is an example of a read side reset transistor recited in claims. The amplification transistor 126 is an example of a reference side amplification transistor recited in claims, and the amplification transistor 136 is an example of a read side amplification transistor recited in claims. The selection transistor 125 is an example of a reference side selection transistor recited in claims, and the selection transistor 135 is an example of a read side selection transistor recited in claims.

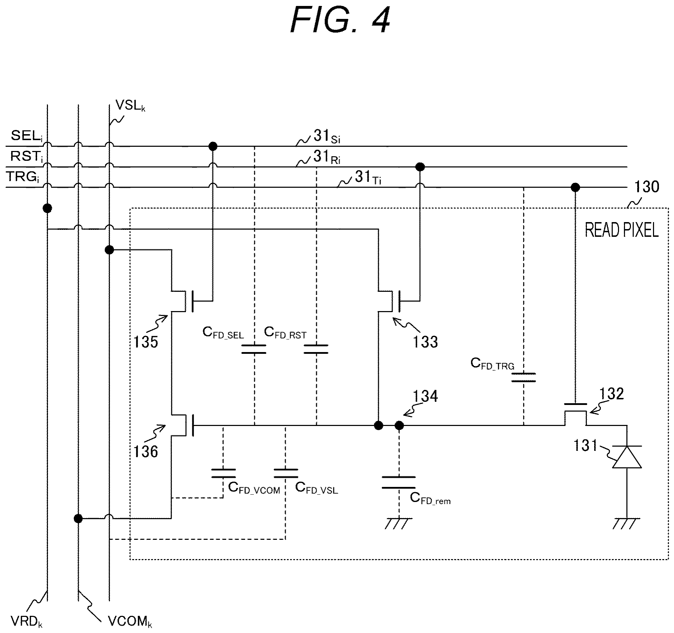

Fig. 4 is a circuit diagram illustrating an example of a parasitic capacitance in the read pixel 130 according to the first embodiment of the present technology. For example, a parasitic capacitance of $C_{FD\_SEL}$ is generated between the selection line $31_{Si}$ and the floating diffusion layer 134, and a parasitic capacitance of $C_{FD\_RST}$ is generated between the reset line $31_{Ri}$ and the floating diffusion layer 134. A parasitic capacitance of $C_{FD\_TRG}$ is generated between the transfer line $31_{Ti}$ and the floating diffusion layer 134.

Furthermore, a parasitic capacitance of $C_{FD\_VCOM}$ is generated between the vertical current supply line $VCOM_k$ and the floating diffusion layer 134, and a parasitic capacitance of $C_{FD\_VSL}$ is generated between the vertical signal line $VSL_k$ and the floating diffusion layer 134. A capacitance remained after various parasitic capacitances such as $C_{FD\_SEL}$ are removed from a total capacitance of the floating diffusion layer is set as $C_{FD\_rem}$.

As illustrated in the drawing, there is the parasitic capacitance between the wires in the horizontal and vertical directions and the floating diffusion layer 134 in the pixel array unit 11, and a plurality of wires is capacitively coupled to the floating diffusion layer 134 through these parasitic capacitances. For example, the vertical current supply line $VCOM_k$ and the transfer line $31_{Ti}$ are capacitively coupled to the floating diffusion layer 134.

A capacitance value of the parasitic capacitance in the drawing is, for example, equal to or larger than 1 atofarad (aF). Although there strictly is the parasitic capacitance smaller than 1 atofarad (aF), this hardly contributes to a potential increase amount of the floating diffusion layer 134 and may be ignored.

[Configuration example of column read circuit unit]

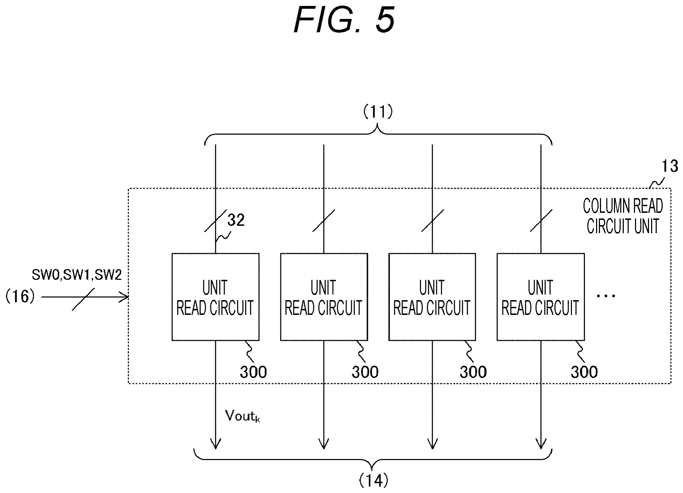

Fig. 5 is a block diagram illustrating a configuration example of the column read circuit unit 13 according to the first embodiment of the present technology. In the column read circuit unit 13, a unit read circuit 300 is arranged for each column. The unit read circuit 300 reads a pixel signal $Vout_k$ of a corresponding column and outputs the same to the column signal processing unit 14. Control signals SW0, SW1, and SW2 from the system control unit 16 are input to each of the unit read circuits 300.

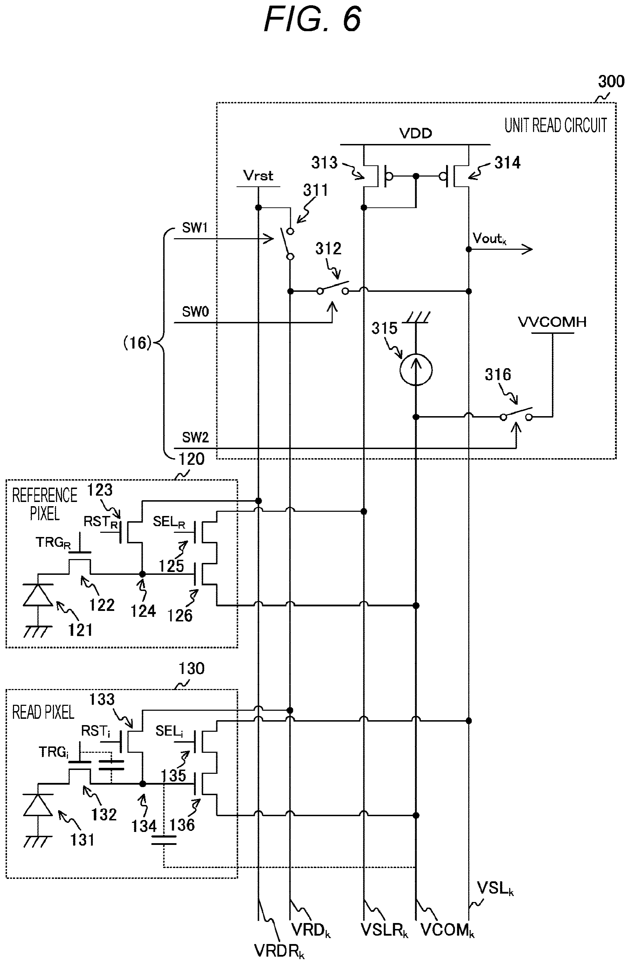

Fig. 6 is a circuit diagram illustrating a configuration example of the unit read circuit 300, the reference pixel 120, and the read pixel 130 according to the first embodiment of the present technology.

The unit read circuit 300 is provided with switches 311, 312, and 316, p-channel metal oxide semiconductor (pMOS) transistors 313 and 314, and a tail current source 315.

The vertical reset input line $VRDR_k$ is connected to a node of a predetermined reset voltage Vrst. The pMOS transistors 313 and 314 are connected in parallel to a node of a power supply voltage VDD. Furthermore, a gate and a drain of the pMOS transistor 313 are short-circuited, and the drain is connected to the vertical signal line $VSLR_k$. In contrast, a gate of the pMOS transistor 314 is connected to the gate of the pMOS transistor 313, and a drain thereof is connected to the vertical signal line $VSL_k$. Furthermore, the pixel signal $Vout_k$ is output from the drain of the pMOS transistor 314. The tail current source 315 is inserted between the vertical current supply line $VCOM_k$ and a node of a reference potential (such as ground potential).

The switch 311 opens and closes a path between the vertical reset input line $VRDR_k$ and the vertical reset input line $VRD_k$ according to the control signal SW1 from the system control unit 16.

The switch 312 opens and closes a path between the vertical reset input line $VRD_k$ and the vertical signal line $VSL_k$ according to the control signal SW0 from the system control unit 16.

The switch 316 opens and closes a path between the vertical current supply line $VCOM_k$ and a node of a predetermined potential VVCOMH according to the control signal SW2 from the system control unit 16.

With the circuit configuration illustrated in the drawing, when the switch 311 is in an open state and the switch 312 is in a closed state, the circuit including the unit read circuit 300, the reference pixel 120, and the read pixel 130 forms a differential amplifier circuit. With this differential amplifier circuit, a signal obtained by differential amplification of the voltage of the floating diffusion layer 124 in the reference pixel 120 as a reference voltage and a voltage of the floating diffusion layer 134 in the read pixel 130 as a read voltage is output as the pixel signal $Vout_k$.

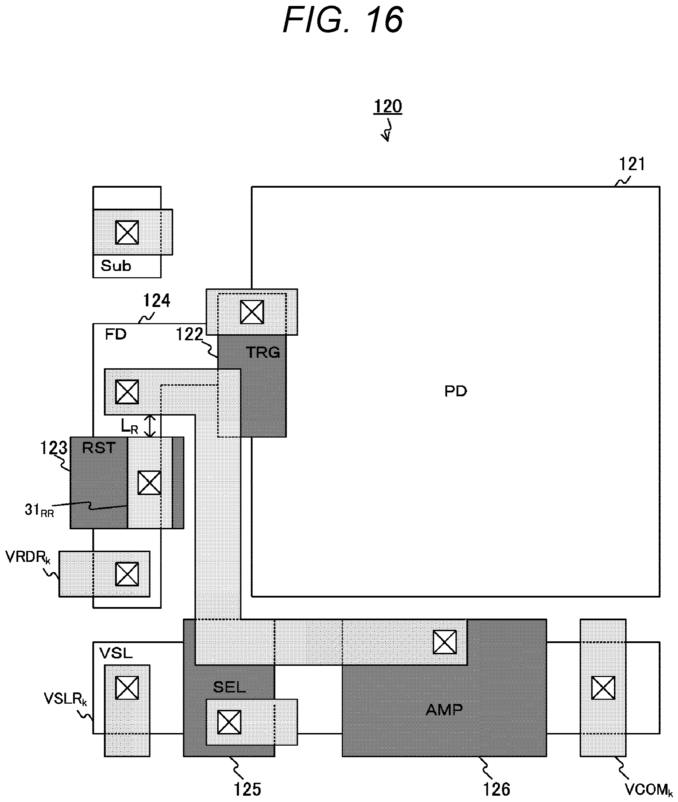

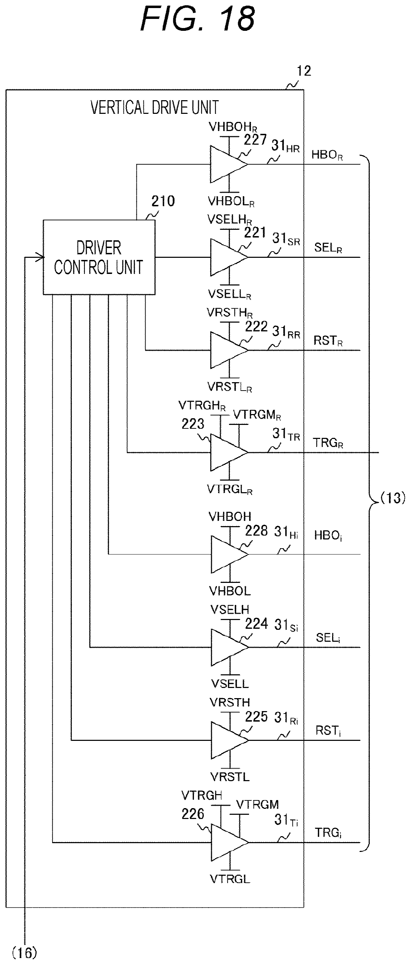

Note that, although a position of the reference pixel 120 is fixed, the configuration is not limited to this. One of a pair of adjacent pixels may be made the reference pixel and the other may be made the read pixel, and these pixels may be replaceable. In this case, for example, the switch disclosed in Fig. 16 of Japanese Patent Application Laid-Open No. 2018-182496 is added. A control timing of these switches is disclosed in Fig. 18 of Japanese Patent Application Laid-Open No. 2018-182496.

[Operation example of CMOS image sensor]

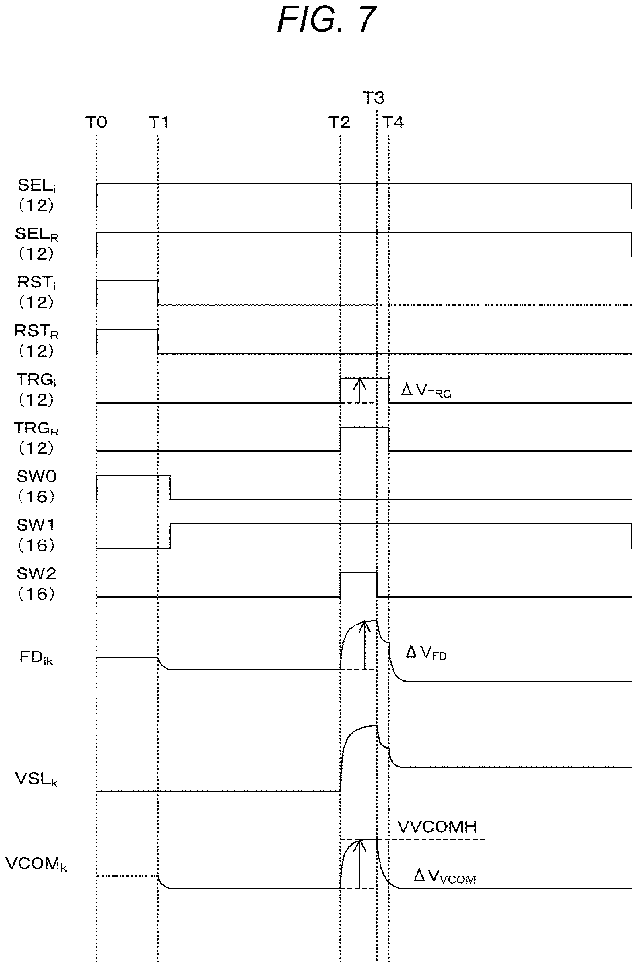

Fig. 7 is a timing chart illustrating an example of a read operation of the CMOS image sensor 10 according to the first embodiment of the present technology. The read operation in the drawing illustrates the read operation of the i-th row out of the I rows in the read pixel region 112. When reading (i+1)-th and subsequent rows, the row to be read is changed, and the control illustrated in the drawing is repeatedly executed.

The vertical drive unit 12 sets the selection signals $SEL_i$ and $SEL_R$ to a high level. A selection signal of a row not to be read such as a selection signal $SEL_{i+1}$ is controlled to a low level.

In an initialization period from a timing T0 immediately before end of exposure to a timing T1 when a predetermined pulse period elapses, the vertical drive unit 12 sets the reset signals $RST_i$ and $RST_R$ to a high level. Therefore, a floating diffusion layer $FD_{ik}$ of the read pixel 130 is initialized.

Furthermore, the system control unit 16 changes the control signal SW0 from a high level to a low level immediately after the timing T1, and causes transition of the corresponding switch 312 from the closed state to an open state. Furthermore, the system control unit 16 changes the control signal SW1 from a low level to a high level immediately after the timing T1, and causes transition of the corresponding switch 311 from the open state to a closed state. Therefore, the differential amplifier circuit is formed, and a reset level at the time of initialization is read.

Then, in a transfer period from a timing T2 when the exposure ends to a timing T4 when a pulse period elapses, the vertical drive unit 12 sets the transfer signals $TRG_i$ and $TRG_R$ to a high level. An increase amount of the transfer signal $TRG_i$ at that time is set to $\Delta V_{TRG}$. Therefore, the voltage of the floating diffusion layer 134 increases, and charge transfer from the photoelectric conversion element 131 to the floating diffusion layer 134 is started. A voltage increase amount of the floating diffusion layer 134 at that time is set to $\Delta V_{FD}$. Furthermore, a voltage of the vertical signal line $VSL_k$ also increases to reach a signal level corresponding to an exposure amount after a settling time elapses.

Furthermore, in a period between the timing T2 and a timing T3 immediately before the timing T4, the system control unit 16 sets the control signal SW2 to a high level and closes the corresponding switch 316. Therefore, a potential of the vertical current supply line $VCOM_k$ in the transfer period increases to the potential VVCOMH higher than that outside the transfer period. An increase amount of the vertical current supply line $VCOM_k$ at that time is set to $\Delta V_{VCOM}$.

Here, a comparative example without the switch 316 provided in which the potential of the vertical current supply line $VCOM_k$ does not increase in the transfer period is assumed. In this comparative example, the voltage increase amount $\Delta V_{FD}$ of the floating diffusion layer 134 at the time of charge transfer is a value corresponding to the increase amount $\Delta V_{TRG}$ of the transfer signal $TRG_i$, and is expressed by, for example, the following expression.

$$\Delta V_{FD} \;=\; \Delta V_{TRG}(C_{FD\_TRG}/C_{FD\_total})...\text{Expression 1}$$

In the expression above, $C_{FD\_total}$ represents the total capacitance of the floating diffusion layer 134.

In contrast to this comparative example, in the configuration provided with the switch 316, since the vertical current supply line $VCOM_k$ is capacitively coupled to the floating diffusion layer 134, the voltage increase amount $\Delta V_{FD}$ is a value corresponding to the increase amounts $\Delta V_{TRG}$ and $\Delta V_{VCOM}$, and is expressed by, for example, the following expression.

$$\Delta V_{FD} \;=\; \Delta V_{VCOM}(C_{FD\_VCOM}/C_{FD\_total})$$
$$+\; \Delta V_{TRG}(C_{FD\_TRG}/C_{FD\_total})...\text{Expression 2}$$

As illustrated in expressions 1 and 2, by providing the switch 316 and increasing the potential of the vertical current supply line $VCOM_k$ in the transfer period, the voltage increase amount $\Delta V_{FD}$ may be made larger than that in the comparative example without the switch 316 provided. Since the transferred charge is an electron, as the voltage increase amount $\Delta V_{FD}$ increases, a potential gradient increases, and charge transfer efficiency may be improved. Note that the switch 316 is an example of a potential control unit recited in claims.

Note that although the switch 316 increases the potential of the vertical current supply line $VCOM_k$ in the transfer period, it is also possible to increase a potential of a signal line other than the vertical current supply line $VCOM_k$ as long as a parasitic capacitance of a constant value (1 aF and the like) or larger is generated between the same and the floating diffusion layer 134. For example, the switch may also increase the potential of the vertical signal line $VSL_k$ as described later.

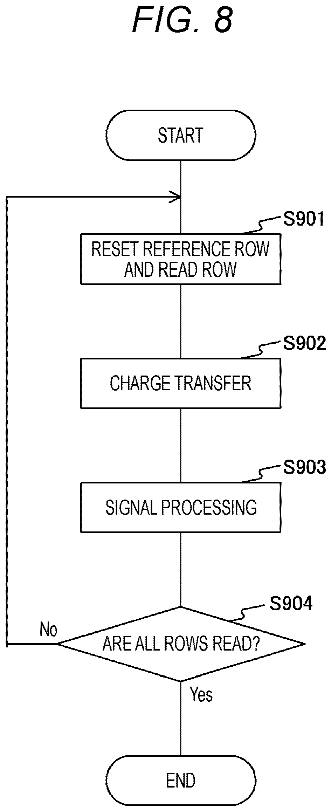

Fig. 8 is a flow chart illustrating an example of an operation of the CMOS image sensor 10 according to the first embodiment of the present technology. This operation starts, for example, when a predetermined application for imaging image data is executed.

The vertical drive unit 12 resets a floating diffusion layer of a reference row in which the reference pixels 120 are arrayed and a read row to be read by a reset signal (step S901). Then, the vertical drive unit 12 increases the potential of the vertical current supply line VCOMk while setting a transfer signal to a high level, and transfers the charge to the floating diffusion layer (step S902).

The column signal processing unit 14 performs signal processing such as CDS processing on the pixel signal for each column (step S903). Then, the CMOS image sensor 10 determines whether or not all the rows are read (step S904). In a case where not all the rows are read (step S904: No), the CMOS image sensor 10 changes the row to be read and repeatedly executes step S901 and subsequent steps.

In a case where all the rows are read (step S904: Yes), the CMOS image sensor 10 ends the operation for reading. In a case of imaging a plurality of image data, the processing at steps S901 to S904 is repeatedly executed in synchronization with a vertical synchronization signal and the like.

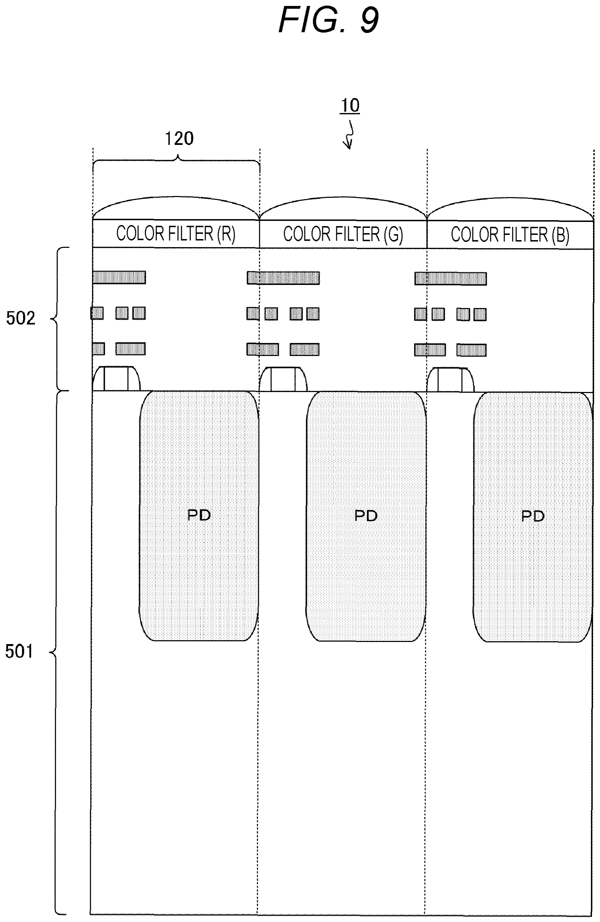

Fig. 9 is an example of a cross-sectional view of the CMOS image sensor 10 according to the first embodiment of the present technology. A wiring layer 502 is arranged below a microlens, and a photoelectric conversion layer 501 is provided below the same. A transistor such as the transfer transistor 132 and a signal line such as the vertical current supply line $VCOM_k$ are provided in the wiring layer 502. In the photoelectric conversion layer 501, the photoelectric conversion elements 121 and 131 are arranged.

As illustrated in the drawing, in the CMOS image sensor 10 in which the wiring layer 502 is arranged between the microlens and the photoelectric conversion layer 501, a front surface that is a surface on which a circuit is arranged is irradiated with light. Such solid-state imaging device is referred to as a front surface irradiation solid-state imaging device.

As described above, according to the first embodiment of the present technology, since the switch 316 increases the potential in the transfer period of the vertical current supply line $VCOM_k$ capacitively coupled to the floating diffusion layer 134, the voltage increase amount $\Delta V_{FD}$ of the floating diffusion layer 134 may be increased according to the increase amount. Therefore, the charge transfer efficiency from the photoelectric conversion element 131 to the floating diffusion layer 134 may be improved. Furthermore, since sensitivity of the pixel is increased by such improvement in the charge transfer efficiency, an image quality of the image data may be improved.

<2. Second Embodiment>

In the first embodiment described above, the potential VVCOMH is supplied to the vertical current supply line $VCOM_k$, but in this configuration, a circuit (constant voltage source and the like) that supplies the potential VVCOMH is required. A CMOS image sensor 10 of a second embodiment is different from that of the first embodiment in that a switch that connects a vertical current supply line $VCOM_k$ to a vertical signal line $VSL_k$ is provided and a constant voltage source and the like is not necessary.

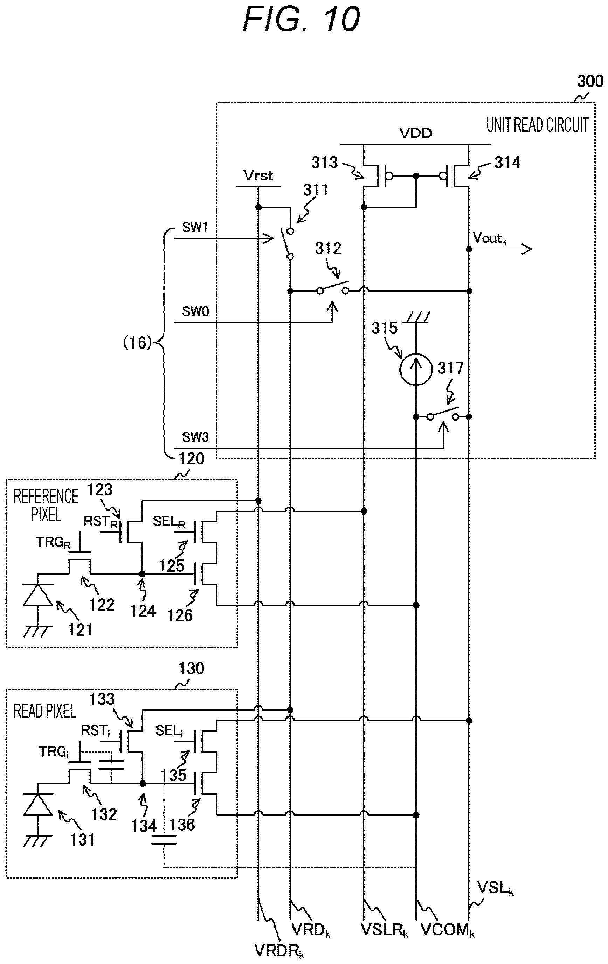

Fig. 10 is a circuit diagram illustrating a configuration example of a unit read circuit 300, a reference pixel 120, and a read pixel 130 according to the second embodiment of the present technology. The unit read circuit 300 of the second embodiment is different from that of the first embodiment in that a switch 317 is provided in place of a switch 316.

The switch 317 opens and closes a path between the vertical current supply line $VCOM_k$ and the vertical signal line $VSL_k$ according to a control signal SW3 from a system control unit 16.

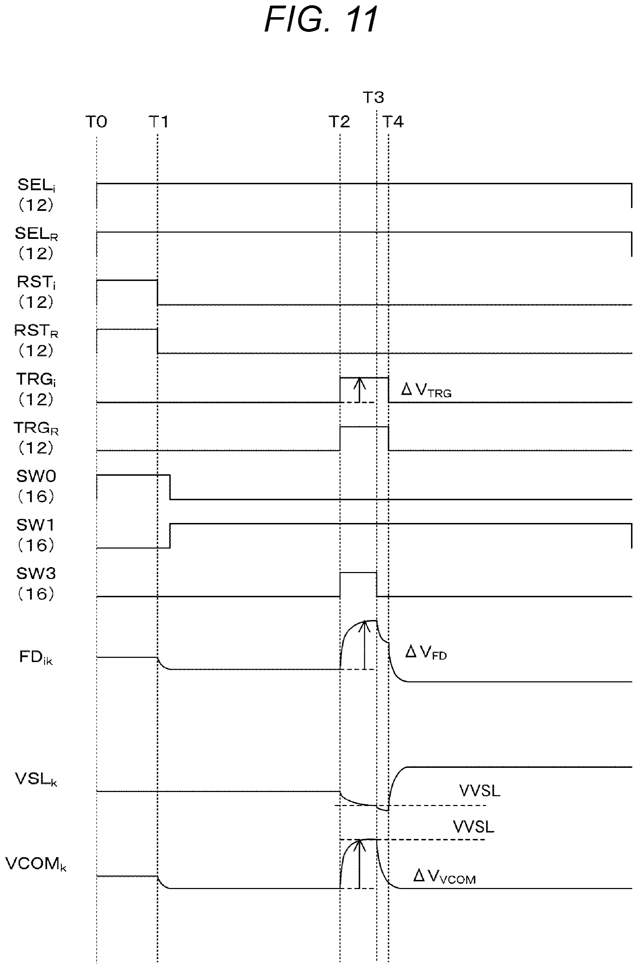

Fig. 11 is a timing chart illustrating an example of a read operation of the CMOS image sensor 10 according to the second embodiment of the present technology.

In a period from a timing T2 to a timing T3 in a transfer period, the system control unit 16 sets the control signal SW3 to a high level and closes the corresponding switch 317. Therefore, the vertical current supply line $VCOM_k$ is connected to the vertical signal line $VSL_k$, and a potential of the vertical current supply line $VCOM_k$ increases to a value equivalent to a potential VVSL of the vertical signal line $VSL_k$. A voltage increase amount $\Delta V_{FD}$ is expressed by expression 2 as in the first embodiment. Note that the switch 317 is an example of a potential control unit recited in claims.

As described above, according to the second embodiment of the present technology, since the switch 317 connects the vertical current supply line $VCOM_k$ to the vertical signal line $VSL_k$, the potential of the vertical current supply line $VCOM_k$ may be increased without providing the constant voltage source and the like.

<3. Third Embodiment>

In the first embodiment described above, the potential of the vertical current supply line $VCOM_k$ is increased; however, since the voltage increase amount $\Delta V_{FD}$ of this configuration depends on the parasitic capacitance $C_{FD\_VCOM}$ as illustrated in expression 2, if the parasitic capacitance $C_{FD\_VCOM}$ is small, the voltage increase amount might be insufficient. A CMOS image sensor 10 of a third embodiment is different from that of the first embodiment in that a potential of a vertical signal line $VSL_k$ is increased.

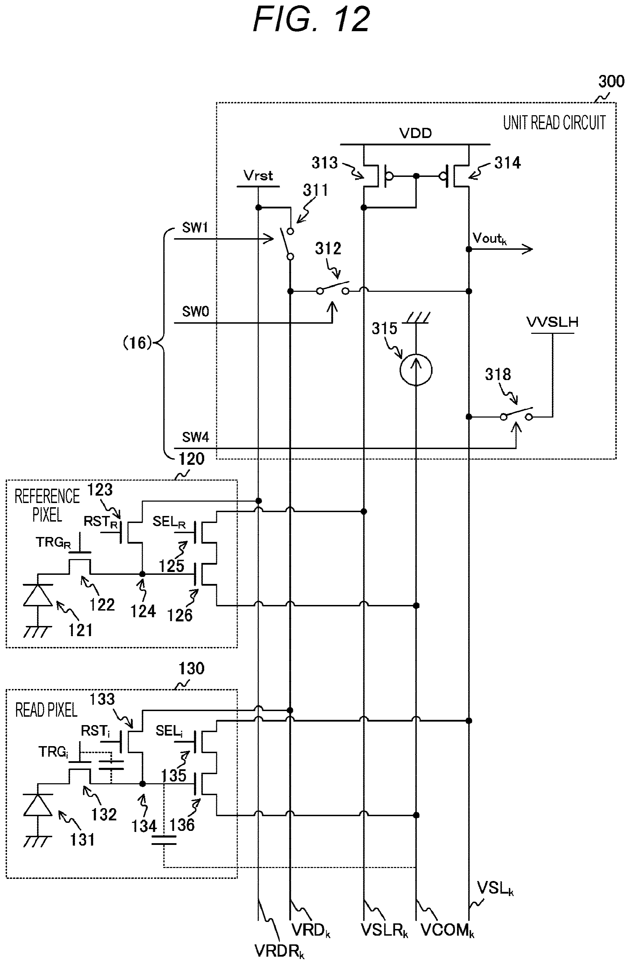

Fig. 12 is a circuit diagram illustrating a configuration example of a unit read circuit 300, a reference pixel 120, and a read pixel 130 according to the third embodiment of the present technology. The unit read circuit 300 of the third embodiment is different from that of the first embodiment in that a switch 318 is provided in place of a switch 316.

The switch 318 opens and closes a path between the vertical signal line $VSL_k$ and a node of a predetermined potential VVSLH according to a control signal SW4 from a system control unit 16. For example, the same potential as a power supply voltage VDD is set as the potential VVSLH.

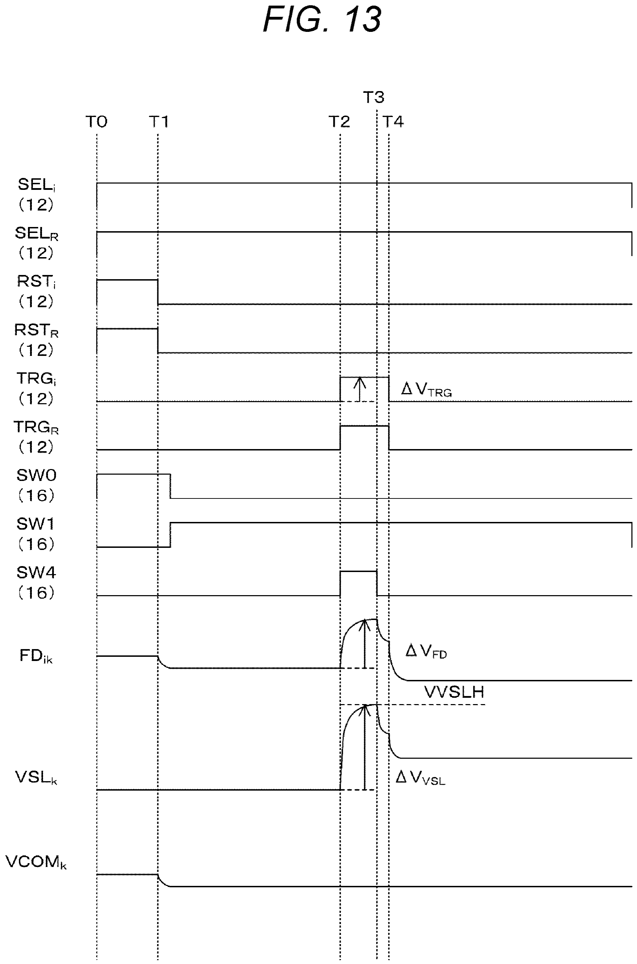

Fig. 13 is a timing chart illustrating an example of a read operation of the CMOS image sensor 10 according to the third embodiment of the present technology.

In a period from a timing T2 to a timing T3 in a transfer period, the system control unit 16 sets the control signal SW4 to a high level and closes the corresponding switch 318. Therefore, the potential of the vertical signal line $VSL_k$ in the transfer period increases to the potential VVSLH higher than that outside the transfer period. An increase amount of the vertical signal line $VSL_k$ at that time is set to $\Delta V_{VSL}$. The voltage increase amount $\Delta V_{FD}$ at that time is expressed by the following expression.

$$\Delta V_{FD} = \Delta V_{VSL}(C_{FD\_VSL}/C_{FD\_total})$$
$$+ \Delta V_{TRG}(C_{FD\_TRG}/C_{FD\_total})...\text{Expression 3}$$

From expression 3, the voltage increase amount $\Delta V_{FD}$ is larger than that in a case where the switch 318 is not provided. Note that the switch 316 of the first embodiment and the switch 317 of the second embodiment may be further added to the third embodiment.

As described above, according to the third embodiment of the present technology, since the switch 318 increases the potential of the vertical signal line $VSL_k$ in the transfer period, the voltage increase amount $\Delta V_{FD}$ of a floating diffusion layer 134 may be increased according to the increase amount.

<4. Fourth Embodiment>

In the first embodiment described above, the potential of the transfer signal is controlled to either the high level or the low level, but in this configuration, there is a possibility that a part of the charge transferred to the floating diffusion layer 134 returns to the photoelectric conversion element 131. A CMOS image sensor 10 of a fourth embodiment is different from that of the first embodiment in that a potential of a transfer signal is controlled to any one of three values of a high level, a middle level, and a low level.

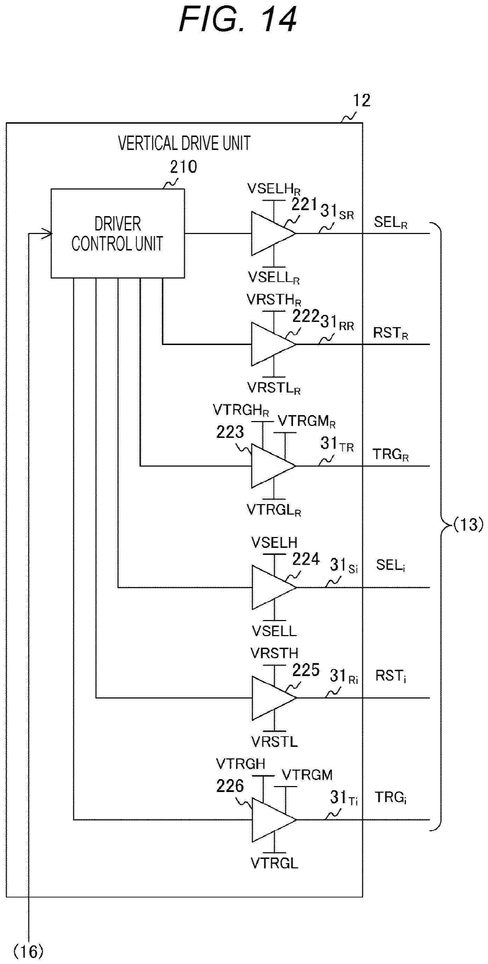

Fig. 14 is a block diagram illustrating a configuration example of a vertical drive unit 12 according to the fourth embodiment of the present technology. The vertical drive unit 12 of the fourth embodiment is provided with a driver control unit 210 and drivers 221 to 226. Among them, the drivers 224 to 226 are arranged for each row in a read pixel region 112.

The driver control unit 210 controls an operation of each of the drivers 221 to 226.

The driver 221 supplies either a potential $VSELH_R$ or a potential $VSELL_R$ different from each other to a selection line $31_{SR}$ under control of the driver control unit 210. High level $VSELH_R$ is, for example, a potential higher than low level $VSELL_R$. A signal of the potentials is supplied to a reference row as a selection signal $SEL_R$.

The driver 222 supplies either a potential $VRSTH_R$ or a potential $VRSTL_R$ different from each other to a reset line $31_{RR}$ under control of the driver control unit 210. High level $VRSTH_R$ is, for example, a potential higher than low level $VRSTL_R$. A signal of the potentials is supplied to the reference row as a reset signal $RST_R$.

The driver 223 supplies any one of potentials $VTRGH_R$, $VTRGM_R$, and $VTRGL_R$ different from each other to a transfer line $31T_R$ under control of the driver control unit 210. High level $VTRGH_R$ is, for example, a potential higher than middle level $VTRGM_R$, and middle level $VTRGM_R$ is a potential higher than low level $VTRGL_R$. A signal of the potentials is supplied to the reference row as a transfer signal $TRG_R$.

The driver 224 supplies either a potential VSELH or a potential VSELL different from each other to a selection line $31_{Si}$ under control of the driver control unit 210. High level VSELH is, for example, a potential higher than low level VSELL. A signal of the potentials is supplied to a corresponding read row as a selection signal $SEL_i$.

The driver 225 supplies either a potential VRSTH or a potential VRSTL different from each other to a reset line $31_{Ri}$ under control of the driver control unit 210. High level VRSTH is, for example, a potential higher than low level VRSTL. A signal of the potentials is supplied to a corresponding read row as a reset signal $RST_i$.

The driver 226 supplies any one of potentials VTRGH, VTRGM, and VTRGL different from each other to a transfer line $31_{Ti}$ under control of the driver control unit 210. High level VTRGH is, for example, a potential higher than middle level VTRGM, and middle level VTRGM is a potential higher than low level VTRGL. A signal of the potentials is supplied to a corresponding read row as a transfer signal $TRG_i$.

Note that the drivers 224 to 226 are arranged for each row in the read pixel region 112, but the configuration is not limited to this. It is also possible to configure such that one driver 224, one driver 225, and one driver 226 are arranged, and a row of an output destination is switched by a demultiplexer and the like.

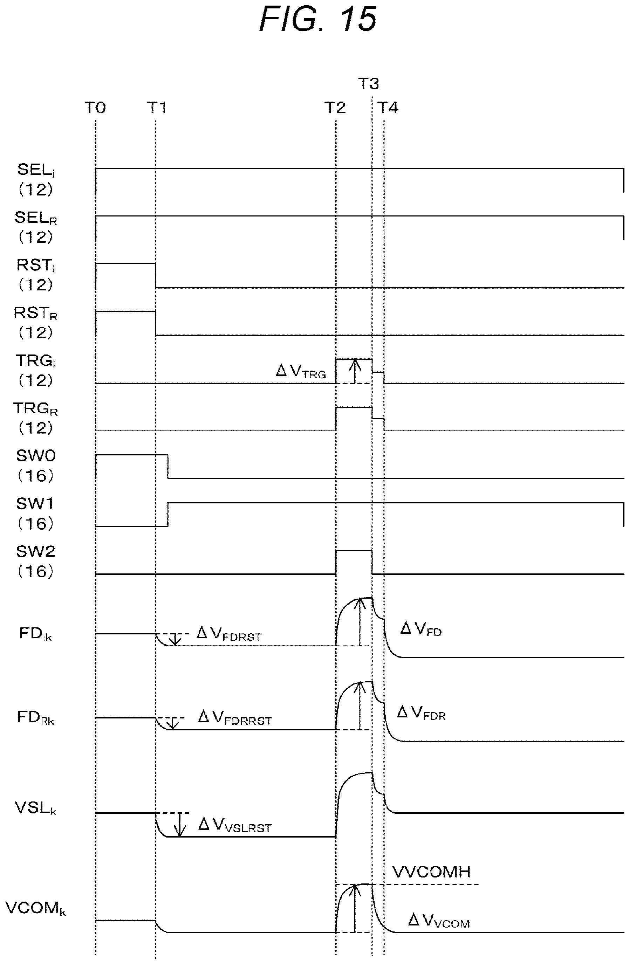

Fig. 15 is a timing chart illustrating an example of a read operation of the CMOS image sensor 10 according to the fourth embodiment of the present technology.

In a reset period from a timing T0 to a timing T1, the vertical drive unit 12 sets potentials of reset signals $RST_R$ and $RST_i$ to a high level as in the first embodiment. However, in the fourth embodiment, the vertical drive unit 12 sets an amplitude of the reset signal $RST_R$ to a value different from that of the reset signal $RST_i$. For example, high level $VRSTH_R$ on a reference side is set to 2.1 volts (V), and low level $VRSTL_R$ is set to 0.0 volt (V). In contrast, high level VRSTH on a read side is set to 2.0 volts (V) lower than that on the reference side, and low level VRSTL is set to 0.0 volt (V).

Note that the vertical drive unit 12 controls the high level of the reset signal to different values between the reference side and the read side, but this may also control the low level to different values between the reference side and the read side in place of this. Furthermore, this may also control both the high level and the low level of the reset signal to different values between the reference side and the read side.

Due to the supply of the above-described reset signal, a reset feedthrough amount is larger on the reference side. Here, when a voltage drop amount of the floating diffusion layer on the reference side is set to $\Delta_{VFDRSTR}$ and a voltage drop amount of the floating diffusion layer on the read side is set to $\Delta V_{FDRST}$, they are expressed by the following expressions.

$$\Delta_{VFDRSTR} = (VRSTH_R - VRSTL_R)(C_{FD\_RSTR}/C_{FD\_total})\ ...Expression\ 4$$

$$\Delta_{VFDRST} = (VRSTH - VRSTL)(C_{FD\_RST}/C_{FD\_total})\ ...Expression\ 5$$

Furthermore, when an open loop gain of a differential amplifier circuit is set to Av, a voltage drop amount $\Delta_{VSLRST}$ of a vertical signal line $VSL_k$ at a reset time is expressed by the following expression.

$$\Delta_{VSLRST} = -Av \cdot (\Delta_{VFDRST} - \Delta_{VFDRSTR})\ ...Expression\ 6$$

As illustrated in expressions 4 to 6, a differential input that is a difference between the voltage drop amount $\Delta_{VFDRSTR}$ on the reference side and the voltage drop amount $\Delta_{VFDRST}$ on the read side is amplified by the open loop gain Av, and a level of the vertical signal line $VSL_k$ is shifted. The open loop gain Av is, for example, -20, and when the differential input is set to 5 millivolts (mV), the level of the vertical signal line $VSL_k$ is shifted by -100 millivolts (mV) from expression 6. As described above, an amplitude range of the vertical signal line VSLk is expanded by 100 millivolts (mV).

Furthermore, at a timing T2 when a transfer period starts, the vertical drive unit 12 controls potentials of the transfer signals $TRG_i$ and $TRG_R$ from a low level to a high level. Then, in a period between a timing T3 and a timing T4 in the transfer period, the vertical drive unit 12 controls the potentials of the transfer signals $TRG_i$ and $TRG_R$ to a middle level. At the timing T4 at the end of the transfer period, the vertical drive unit 12 controls the potentials of the transfer signals $TRG_i$ and $TRG_R$ from the middle level to the low level.

As illustrated in the drawing, by controlling the potential of the transfer signal from the high level to the middle level and from the middle level to the low level, an influence of the feedthrough on the floating diffusion layer is alleviated. Therefore, a pumping phenomenon that a part of the charge transferred from the photoelectric conversion element 131 to the floating diffusion layer 134 returns from the floating diffusion layer 134 to the photoelectric conversion element 131 is less likely to occur.

Fig. 16 is a plan view illustrating a layout example of a reference pixel 120 according to the fourth embodiment of the present technology. In a horizontal direction perpendicular to a vertical signal line VSL in the reference pixel 120, a length of a portion where a wire (reset line $31_{RR}$) connected to a reset transistor 123 and a wire that connects an amplification transistor 126 to a floating diffusion layer 124 are the closest is set to $L_R$.

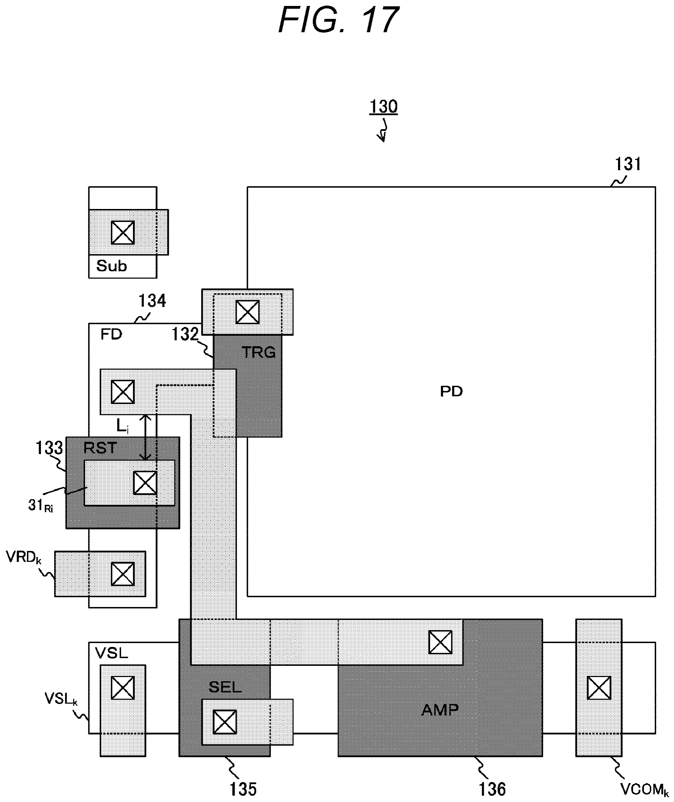

Fig. 17 is a plan view illustrating a layout example of a read pixel 130 according to the fourth embodiment of the present technology. In a horizontal direction in the read pixel 130, a length of a portion where a wire (reset line $31_{Ri}$) connected to the reset transistor 123 and a wire that connects the amplification transistor 126 to the floating diffusion layer 124 are the closest is set to $L_i$.

When the layout in Fig. 16 is compared with the layout in Fig. 17, shapes of predetermined signal lines in which a parasitic capacitance is generated between the same and the floating diffusion layer are different from each other. For example, the shape of the reset line $31_{RR}$ in which there is a parasitic capacitance $C_{FD\_RSTR}$ in the reference pixel 120 is different from the shape of the reset line $31_{Ri}$ in which there is a parasitic capacitance $C_{FD\_RST}$ in the read pixel 130. For example, the reset line $31_{RR}$ is wired in a vertical direction, whereas the reset line $31_{Ri}$ is wired in the horizontal direction. As a result, the length $L_R$ on the reference side is shorter than the length $L_i$ on the read side. Due to this difference in wiring layout, the parasitic capacitance $C_{FD\_RSTR}$ and the parasitic capacitance $C_{FD\_RST}$ have different values. By setting the parasitic capacitance $C_{FD\_RSTR}$ and the parasitic capacitance $C_{FD\_RST}$ to different values, the level of the vertical signal line $VSL_k$ may be further shifted by expressions 4 to 6.

Note that the vertical drive unit 12 sets the amplitude of the reset signal $RST_R$ to a value different from that of the reset signal $RST_i$, and further makes the wiring layout of the reference pixel 120 different from the wiring layout of the read pixel 130; however, the configuration is not limited to this. The amplitude of the reset signal $RST_R$ may be set to a value different from that of the reset signal $RST_i$, and the wiring layout of the reference pixel 120 may be made the same as the wiring layout of the read pixel 130. Furthermore, the amplitude of the reset signal $RST_R$ may be set to the same value as that of the reset signal $RST_i$, and the wiring layout of the reference pixel 120 may be made different from the wiring layout of the read pixel 130.

Furthermore, although both expansion of the amplitude of the vertical signal line $VSL_k$ and suppression of the phenomenon that a part of the charge returns to the photoelectric conversion element 131 are performed, it is possible that only one of them is performed. For example, in a case where the amplitude of the vertical signal line $VSL_k$ is not expanded, the amplitude of the reset signal $RST_R$ may be set to the same value as the reset signal $RST_i$, and the wiring layout of the reference pixel 120 may be made the same as the wiring layout of the read pixel 130.

As described above, according to the fourth embodiment of the present technology, since the vertical drive unit 12 controls the potential of the transfer signal from the high level to the middle level in the transfer period, it is possible to suppress the phenomenon that a part of the charge returns to the photoelectric conversion element 131.

<5. Fifth Embodiment>

In the first embodiment described above, the potential of the vertical current supply line $VCOM_k$ is increased; however, since the voltage increase amount $\Delta V_{FD}$ of this configuration depends on the parasitic capacitance $C_{FD\_VCOM}$ as illustrated in expression 2, if the parasitic capacitance $C_{FD\_VCOM}$ is small, the voltage increase amount might be insufficient. A CMOS image sensor 10 of a fifth embodiment is different from that of the first embodiment in that a potential of a potential fluctuation dedicated line wired in a horizontal direction is increased.

Fig. 18 is a block diagram illustrating a configuration example of a vertical drive unit 12 according to the fifth embodiment of the present technology. The vertical drive unit 12 of the fifth embodiment is provided with a driver control unit 210 and drivers 221 to 228. Among them, the drivers 224, 225, 226, and 228 are arranged for each row in a read pixel region 112.

Configurations of the drivers 221 to 226 of the fifth embodiment are similar to those of the fourth embodiment.

The driver 227 supplies either a potential $VHBOH_R$ or a potential $VHBOL_R$ different from each other to a potential fluctuation dedicated line $31_{HR}$ under control of the driver control unit 210. High level $VHBOH_R$ is, for example, a potential higher than low level $VHBOL_R$. A signal of the potentials is supplied to a reference row as a potential signal $HBO_R$.

The driver 228 supplies either a potential VHBOH or a potential VHBOL different from each other to a potential fluctuation dedicated line $31_{Hi}$ under control of the driver control unit 210. High level VHBOH is, for example, a potential higher than low level VHBOL. A signal of the potentials is supplied to a corresponding read row as a potential signal $HBO_i$.

Note that the drivers 223 and 226 perform three-value drive on a transfer transistor, but they are not limited to this configuration and may also perform two-value drive. Furthermore, the drivers 227 and 228 are an example of a potential control unit recited in claims.

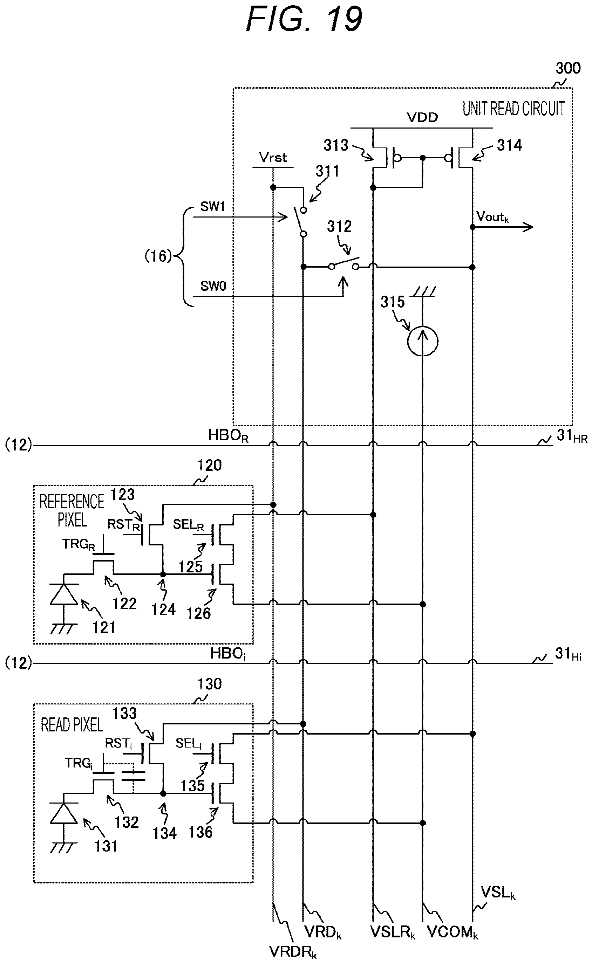

Fig. 19 is a circuit diagram illustrating a configuration example of a unit read circuit 300, a reference pixel 120, and a read pixel 130 according to the fifth embodiment of the present technology. The unit read circuit 300 of the fifth embodiment is different from that of the first embodiment in that a switch 316 is not provided.

Furthermore, a potential fluctuation dedicated line $31_{HR}$ is further wired to the reference row in the horizontal direction. A potential fluctuation dedicated line $31_{Hi}$ is further wired in the horizontal direction to each of the rows in the read pixel region 112. The potential fluctuation dedicated lines $31_{HR}$ and $31_{Hi}$ are not connected to a circuit in the pixel.

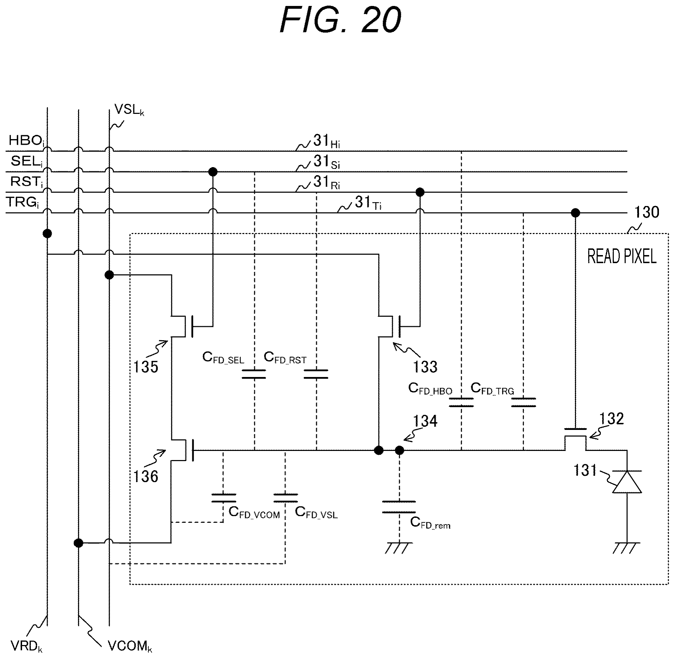

Fig. 20 is a circuit diagram illustrating an example of a parasitic capacitance in the read pixel 130 according to the fifth embodiment of the present technology. There further is a parasitic capacitance $C_{FD\_HBO}$ between the potential fluctuation dedicated line $31_{Hi}$ and a floating diffusion layer 134.

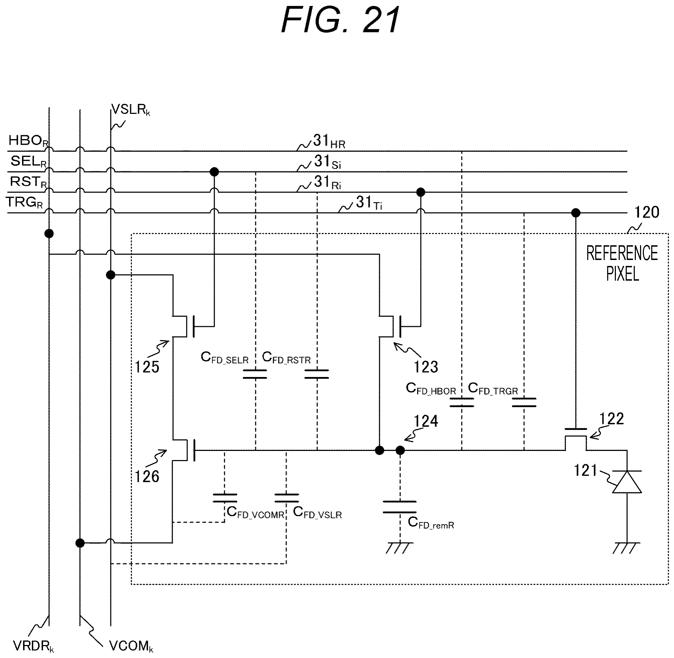

Fig. 21 is a circuit diagram illustrating an example of a parasitic capacitance in the reference pixel 120 according to the fifth embodiment of the present technology. There further is a parasitic capacitance $C_{FD\_HBOR}$ between the potential fluctuation dedicated line $31_{HR}$ and a floating diffusion layer 124.

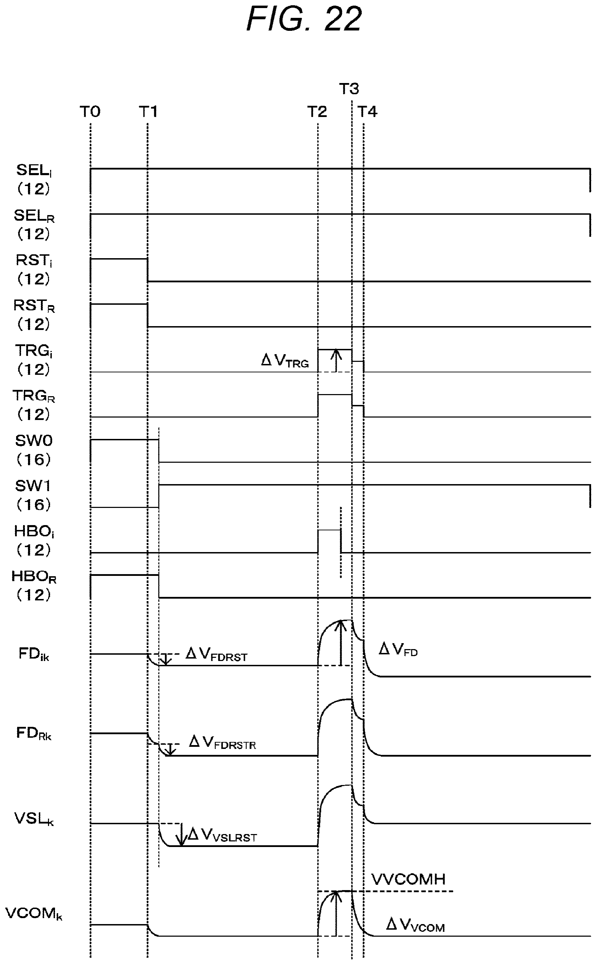

Fig. 22 is a timing chart illustrating an example of a read operation of the CMOS image sensor 10 according to the fifth embodiment of the present technology. The timing chart of the fifth embodiment is different from that of the fourth embodiment in that a potential signal is further transmitted to the potential fluctuation dedicated line.

The vertical drive unit 12 supplies a high level potential signal $HBO_R$ to the potential fluctuation dedicated line $31_{HR}$ over a predetermined pulse period from a timing T0 to immediately after a timing T1. A voltage drop amount $\Delta_{VFDRSTR}$ of the floating diffusion layer on a reference side at that time is expressed by the following expression.

$$\Delta_{\mathrm{VFDRSTR}} =$$

$$(\mathrm{VHBOH_R} - \mathrm{VHBOL_R})(\mathrm{C_{FD\_HBOR}}/\mathrm{C_{FD\_total}})...\text{Expression 7}$$

Furthermore, a voltage drop amount $\Delta_{\mathrm{VSLRST}}$ of a vertical signal line $\mathrm{VSL_k}$ at a reset time is expressed by the following expression.

$$\Delta_{\mathrm{VSLRST}} = -Av \cdot \Delta_{\mathrm{VFDRSTR}}...\text{Expression 8}$$

As illustrated in expressions 7 and 8, the voltage drop amount $\Delta_{\mathrm{VSLRST}}$ of the vertical signal line $\mathrm{VSL_k}$ may be increased according to the parasitic capacitance $\mathrm{C_{FD\_HBOR}}$. Therefore, the amplitude of the potential of the vertical signal line $\mathrm{VSL_k}$ may be expanded.

Furthermore, the vertical drive unit 12 supplies a high level potential signal $\mathrm{HBO_i}$ to the potential fluctuation dedicated line $31_{\mathrm{Hi}}$ over a predetermined pulse period from a timing T2 when transfer starts. The voltage increase amount $\Delta V_{\mathrm{FD}}$ at that time is expressed by the following expression.

$$\Delta V_{\mathrm{FD}} = (\mathrm{VHBOH} - \mathrm{VHBOLR}) \cdot (\mathrm{C_{FD\_HBO}}/\mathrm{C_{FD\_total}})$$

$$+ \Delta V_{\mathrm{TRG}}(\mathrm{C_{FD\_TRG}}/\mathrm{C_{FD\_total}})...\text{Expression 9}$$

Expression 9 may increase the voltage increase amount $\Delta V_{\mathrm{FD}}$ as compared with a case where the potential of the potential fluctuation dedicated line is not controlled.

Note that the switch 316 of the first embodiment may also be applied to the fifth embodiment. Furthermore, each of the second to fourth embodiments may be further applied to the fifth embodiment.

As described above, according to the fifth embodiment of the present technology, since the vertical drive unit 12 increases the potential of the potential fluctuation dedicated line $31_{\mathrm{Hi}}$ in the transfer period, the voltage increase amount $\Delta V_{\mathrm{FD}}$ of the floating diffusion layer 134 may be increased according to the increase amount.

<6. Sixth Embodiment>

In the first embodiment described above, the potential of the vertical current supply line $\mathrm{VCOM_k}$ is increased; however, since the voltage increase amount $\Delta V_{\mathrm{FD}}$ of this configuration depends on the parasitic capacitance $\mathrm{C_{FD\_VCOM}}$ as illustrated in expression 2, if the parasitic capacitance $\mathrm{C_{FD\_VCOM}}$ is small, the voltage increase amount might be insufficient. A CMOS image sensor 10 of a sixth embodiment is different from that of the first embodiment in that a potential of a potential fluctuation dedicated line wired in a vertical direction is increased.

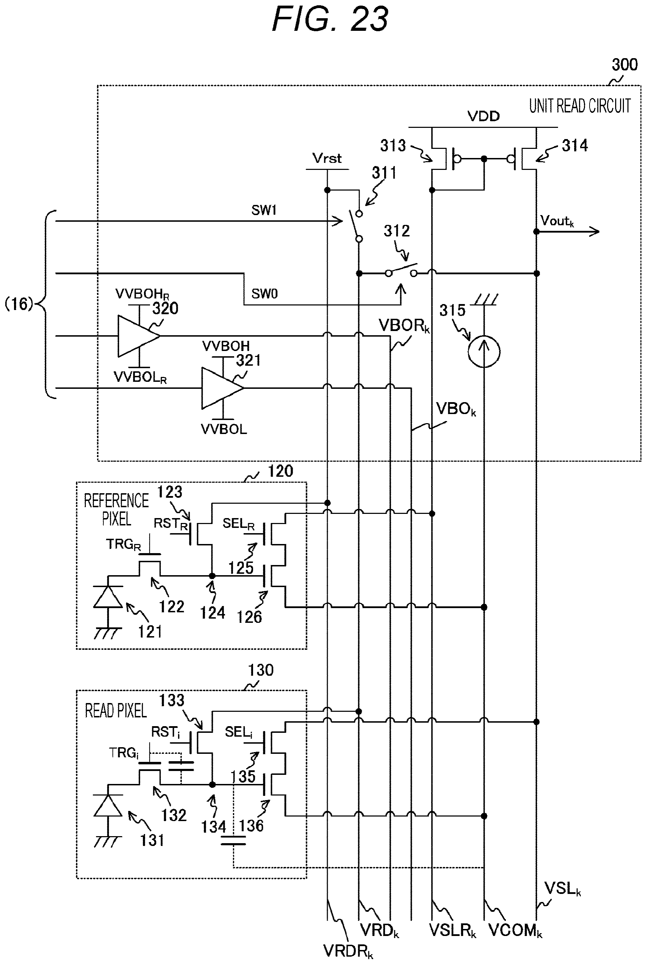

Fig. 23 is a circuit diagram illustrating a configuration example of a unit read circuit 300, a reference pixel 120, and a read pixel 130 in the sixth embodiment of the present technology. The unit read circuit 300 of the sixth embodiment is different from that of the first embodiment in that a switch 316 is not provided and drivers 320 and 321 are further provided.

The driver 320 supplies either a potential $\mathrm{VVBOH_R}$ or a potential $\mathrm{VVBOL_R}$ different from each other to a potential fluctuation dedicated line $\mathrm{VBOR_k}$ under control of a system control unit 16. High level $\mathrm{VVBOH_R}$ is, for example, a potential higher than low level $\mathrm{VVBOL_R}$.

The driver 321 supplies either a potential $\mathrm{VVBOH}$ or a potential $\mathrm{VVBOL}$ different from each other to a potential fluctuation dedicated line $\mathrm{VBO_k}$ under control of the system control unit 16. High level $\mathrm{VVBOH}$ is, for example, a potential higher than low level $\mathrm{VVBOL}$.

Note that the drivers 320 and 321 are an example of a potential control unit recited in claims.

Furthermore, in a pixel array unit 11, the potential fluctuation dedicated line $\mathrm{VBOR_k}$ and the potential fluctuation dedicated line $\mathrm{VBO_k}$ are further wired in the vertical direction for each column. The potential fluctuation dedicated lines $\mathrm{VBOR_k}$ and $\mathrm{VBO_k}$ are not connected to a circuit in the pixel.

Note that, although the drivers 320 and 321 are arranged in each column, the configuration is not limited to this. It is also possible to provide one driver 320 and one driver 321 and share the drivers by all the columns. Furthermore, although the drivers 320 and 321 are arranged in the unit read circuit 300, they may also be arranged in the system control unit 16 or a vertical drive unit 12.

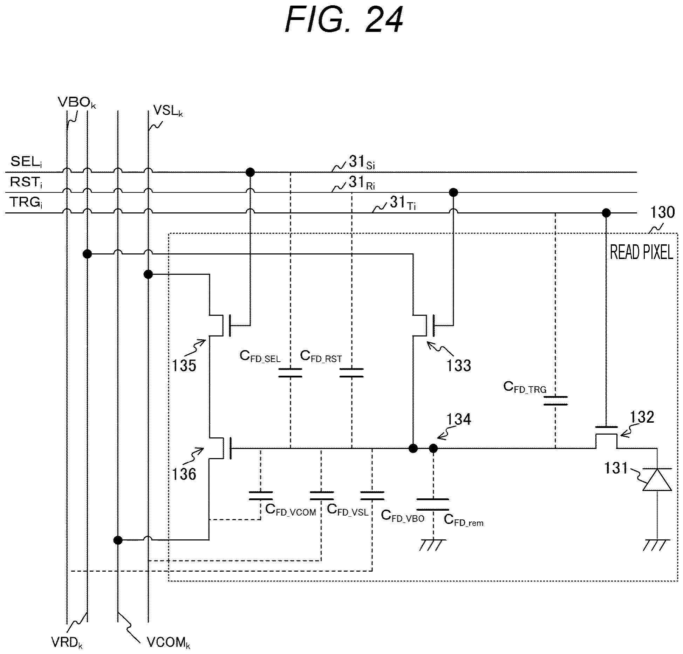

Fig. 24 is a circuit diagram illustrating an example of a parasitic capacitance in the read pixel 130 according to the sixth embodiment of the present technology. There further is a parasitic capacitance $\mathrm{C_{FD\_VBO}}$ between the potential

fluctuation dedicated line VBO$_k$ and a floating diffusion layer 134.

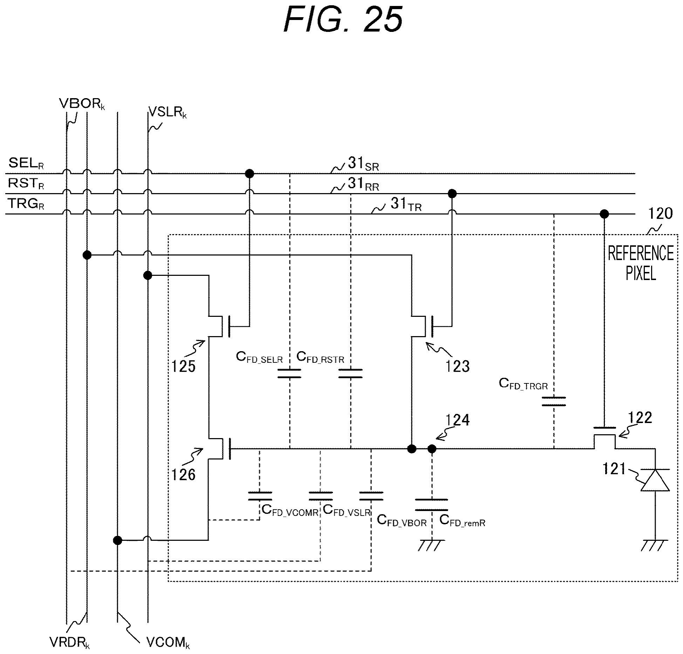

Fig. 25 is a circuit diagram illustrating an example of a parasitic capacitance in the reference pixel 120 according to the sixth embodiment of the present technology. There further is a parasitic capacitance $C_{FD\_VBOR}$ between the potential fluctuation dedicated line VBOR$_k$ and a floating diffusion layer 124.

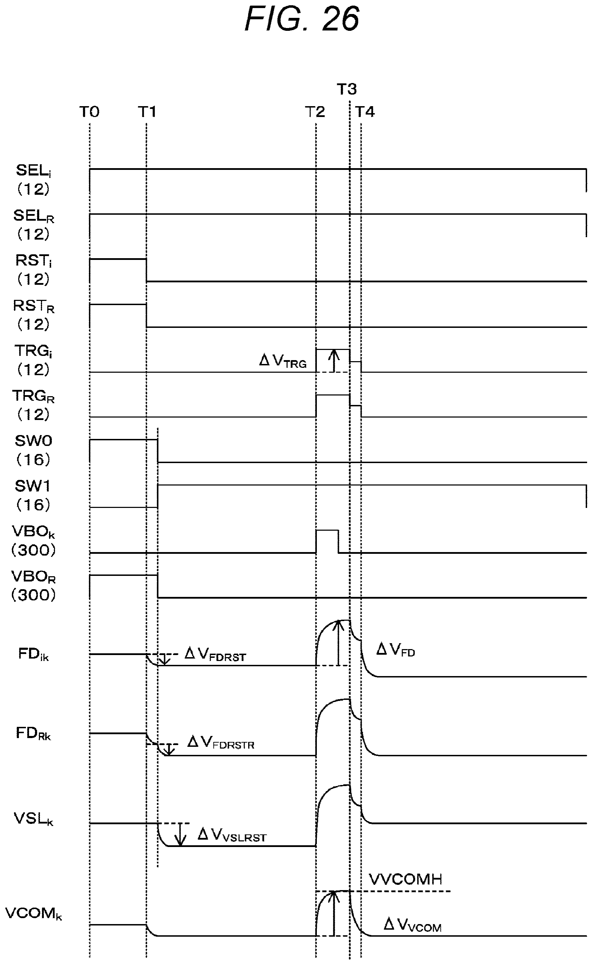

Fig. 26 is a timing chart illustrating an example of a read operation of the CMOS image sensor 10 according to the sixth embodiment of the present technology. The timing chart of the sixth embodiment is different from that of the fourth embodiment in that a potential signal is further transmitted to a potential fluctuation dedicated line.

The unit read circuit 300 supplies a high level potential signal to a potential fluctuation dedicated line VBO$_R$ over a predetermined pulse period from a timing T0 to immediately after a timing T1. A voltage drop amount $\Delta_{VFDRSTR}$ of the floating diffusion layer on a reference side at that time is expressed by the following expression.

$$\Delta_{VFDRSTR} =$$
$$(VVBOH_R - VVBOL_R)(C_{FD\_VBOR}/C_{FD\_total})...Expression\ 10$$

As illustrated in expression 10, a voltage drop amount $\Delta_{VSLRST}$ of a vertical signal line VSL$_k$ may be increased according to the parasitic capacitance $C_{FD\_VBOR}$.

Furthermore, the voltage drop amount $\Delta_{VSLRST}$ of the vertical signal line VSL$_k$ at a reset time is expressed by following expression 8.

Furthermore, the unit read circuit 300 supplies a high level potential signal to the potential fluctuation dedicated line VBO$_k$ over a predetermined pulse period from a timing T2 when transfer starts. The voltage increase amount $\Delta V_{FD}$ at that time is expressed by the following expression.

$$\Delta V_{FD} = (VVBOH - VVBOL) \cdot (C_{FD\_VBO}/C_{FD\_total})$$
$$+ \Delta V_{TRG}(C_{FD\_TRG}/C_{FD\_total})...Expression\ 11$$

Expression 11 may increase the voltage increase amount $\Delta V_{FD}$ as compared with a case where the potential of the potential fluctuation dedicated line is not controlled.

Note that the switch 316 of the first embodiment may also be applied to the sixth embodiment. Furthermore, each of the second to fourth embodiments may be further applied to the sixth embodiment.

As described above, according to the sixth embodiment of the present technology, since the unit read circuit 300 increases the potential of the potential fluctuation dedicated line VBO$_k$ in the transfer period, the voltage increase amount $\Delta V_{FD}$ of the floating diffusion layer 134 may be increased according to the increase amount.

<7. Seventh Embodiment>

In the first embodiment described above, the pixel signal is generated with constant charge-voltage conversion efficiency, but it is desirable to control the charge-voltage conversion efficiency from the viewpoint of reducing noise at low illuminance. A CMOS image sensor 10 of a seventh embodiment is different from that of the first embodiment in that a transistor for controlling the charge-voltage conversion efficiency is provided.

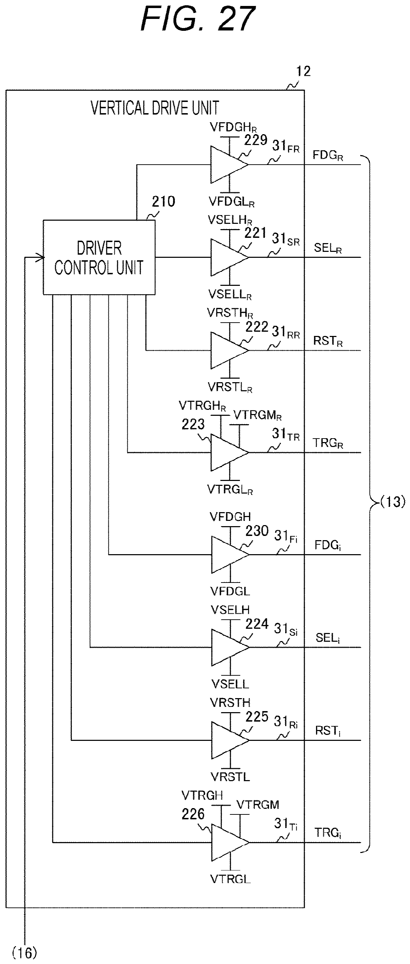

Fig. 27 is a block diagram illustrating a configuration example of a vertical drive unit 12 according to the seventh embodiment of the present technology. The vertical drive unit 12 of the seventh embodiment is provided with a driver control unit 210, drivers 221 to 226, and drivers 229 and 230. Among them, the drivers 224, 225, 226, and 230 are arranged for each row in a read pixel region 112.

Configurations of the drivers 221 to 226 of the seventh embodiment are similar to those of the fourth embodiment.

The driver 229 supplies either a potential VFDGH$_R$ or a potential VFDGL$_R$ different from each other to a control line 31$_{FR}$ under control of the driver control unit 210. High level VFDGH$_R$ is, for example, a potential higher than low level VFDGL$_R$. A signal of the potentials is supplied to a reference row as a control signal FDG$_R$.

The driver 230 supplies either a potential VFDGH or a potential VFDGL different from each other to a control line 31$_{Fi}$ under control of the driver control unit 210. High level VFDGH is, for example, a potential higher than low level VFDGL. A signal of the potentials is supplied to a corresponding read row as a control signal FDG$_i$.

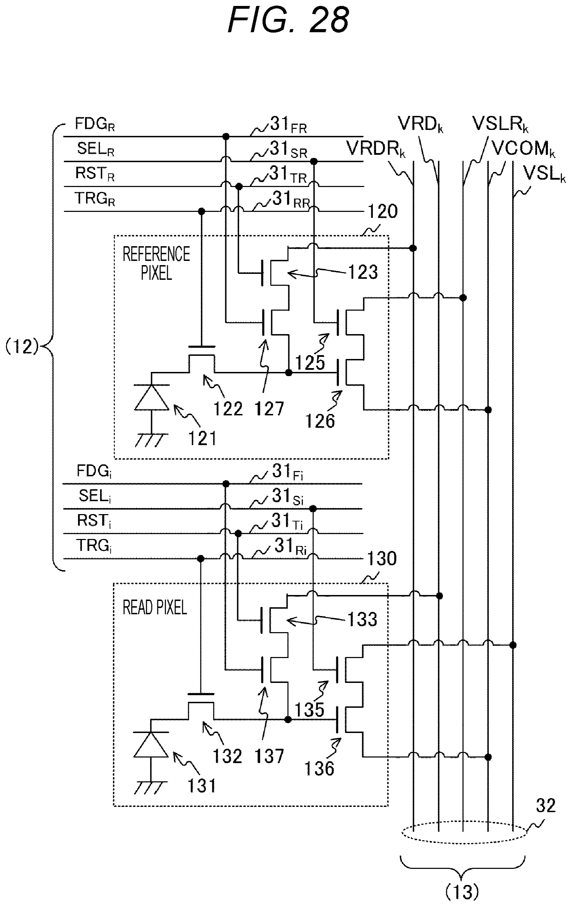

Fig. 28 is a circuit diagram illustrating a configuration example of the reference pixel 120 and a read pixel 130 according to the first embodiment of the present technology. In the reference pixel 120 of the seventh embodiment, a conversion efficiency control transistor 127 is further arranged. Furthermore, in the read pixel 130 of the seventh embodiment, a conversion efficiency control transistor 137 is further arranged.

The conversion efficiency control transistors 127 and 137 are transistors that control conversion efficiency of conversion of a charge into a voltage. The conversion efficiency control transistor 127 on a reference side is inserted between a reset transistor 123 and a floating diffusion layer 124, and a gate thereof is connected to the control line $31_{FR}$. A connection configuration of the conversion efficiency control transistor 137 on a read side is similar to that on the reference side.

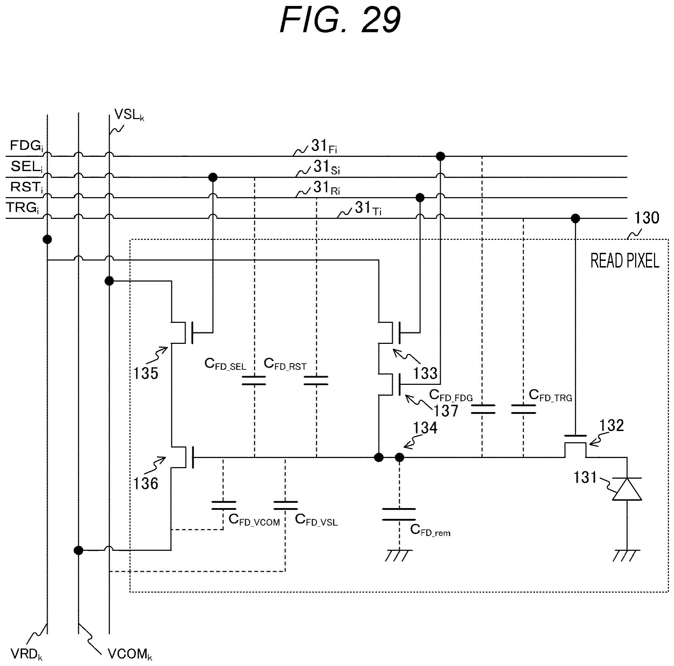

Fig. 29 is a circuit diagram illustrating an example of a parasitic capacitance in the read pixel 130 according to the seventh embodiment of the present technology. There further is a parasitic capacitance $C_{FD\_FDG}$ between the control line $31_{Fi}$ and the floating diffusion layer 134.

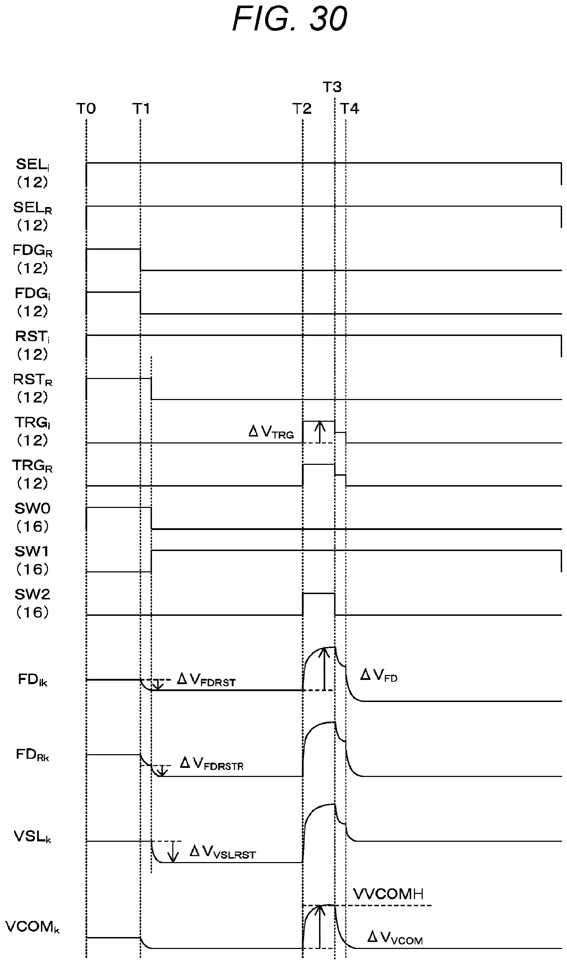

Fig. 30 is a timing chart illustrating an example of a read operation of the CMOS image sensor 10 according to the seventh embodiment of the present technology. The timing chart of the seventh embodiment is different from that of the fourth embodiment in that control signals $FDG_R$ and $FDG_i$ are further transmitted.

In a case of increasing the charge-voltage conversion efficiency, the vertical drive unit 12 sets the control signals $FDG_R$ and $FDG_i$ to a high level over a pulse period from a timing T0 to a timing T1.

In contrast, in a case of lowering the charge-voltage conversion efficiency, the vertical drive unit 12 always sets the control signals $FDG_R$ and $FDG_i$ to the high level.

Note that, in a case of increasing the charge-voltage conversion efficiency, the vertical drive unit 12 may set the control signals $FDG_R$ and $FDG_i$ to the high level also at the time of transfer in addition to the reset time. Therefore, a voltage increase amount $\Delta V_{FD}$ may be further increased according to the parasitic capacitance $C_{FD\_FDG}$. Furthermore, in a case where the control signals $FDG_R$ and $FDG_i$ are set to the high level also at the time of transfer, it is possible that the switch 316 is not provided.

Note that, each of the second to sixth embodiments may be further applied to the seventh embodiment.

As described above, according to the seventh embodiment of the present technology, since the conversion efficiency control transistors 127 and 137 control the charge-voltage conversion efficiency, noise at low illuminance may be reduced.

<8. Eighth Embodiment>

In the first embodiment described above, the structure of the front surface irradiation type is used, but in the front surface irradiation type, sensitivity might be insufficient because light is shielded by a part of a wiring layer. A CMOS image sensor 10 according to an eighth embodiment is different from that of the first embodiment in that a structure of a back surface irradiation type is used.

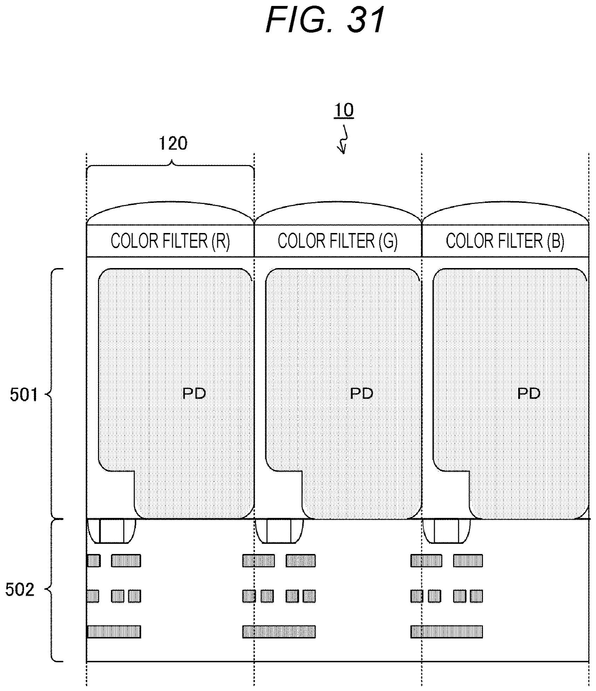

Fig. 31 is an example of a cross-sectional view of the CMOS image sensor according to the eighth embodiment of the present technology. A photoelectric conversion layer 501 is arranged below a microlens, and a wiring layer 502 is provided below the same.

As illustrated in the drawing, in the CMOS image sensor 10 in which the photoelectric conversion layer 501 is arranged between the microlens and the wiring layer 502, a back surface opposed to a front surface is irradiated with light. Such solid-state imaging device is referred to as a back surface irradiation solid-state imaging device. In the back surface irradiation type, light is not shielded by a part of the wiring layer, so that sensitivity may be made higher than that of the front surface irradiation type.

Note that, each of the second to seventh embodiments may be applied to the eighth embodiment.

As described above, according to the eighth embodiment of the present technology, since the back surface irradiation CMOS image sensor 10 is used, the sensitivity may be made higher than that of the front surface irradiation CMOS image sensor.

<9. Ninth Embodiment>

In the first embodiment described above, a constant tail current is supplied, but in this configuration, as the voltage increase amount $\Delta V_{FD}$ of the floating diffusion layer is larger, a settling time becomes longer, and a frame rate might be lowered. A CMOS image sensor 10 of a ninth embodiment is different from that of the first embodiment in that a tail current is increased to shorten a settling time.

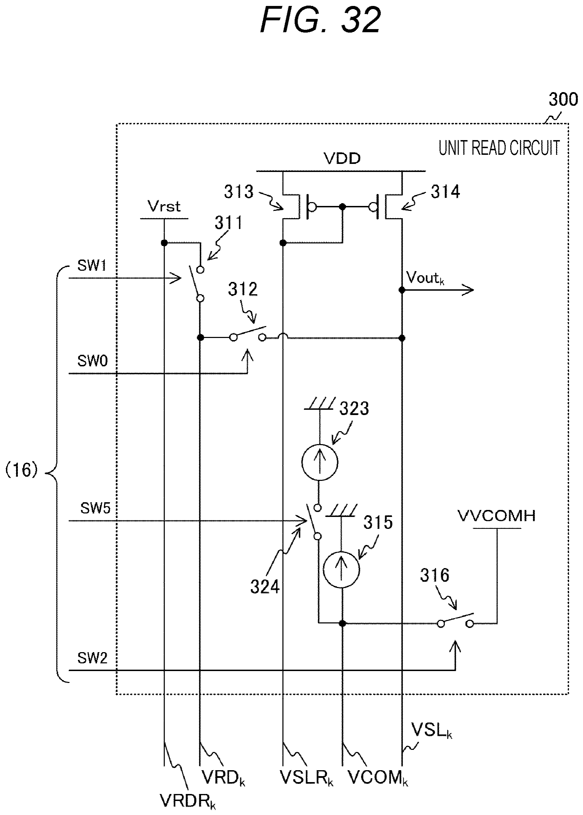

Fig. 32 is a circuit diagram illustrating a configuration example of a unit read circuit 300 in the ninth embodiment of the present technology. The unit read circuit 300 of the ninth embodiment is different from that of the first embodiment in that a switch 324 and a tail current source 323 are further provided.

The switch 324 opens and closes a path between the tail current source 323 and a vertical signal line $VCOM_k$ according to a control signal SW5 from a system control unit 16.

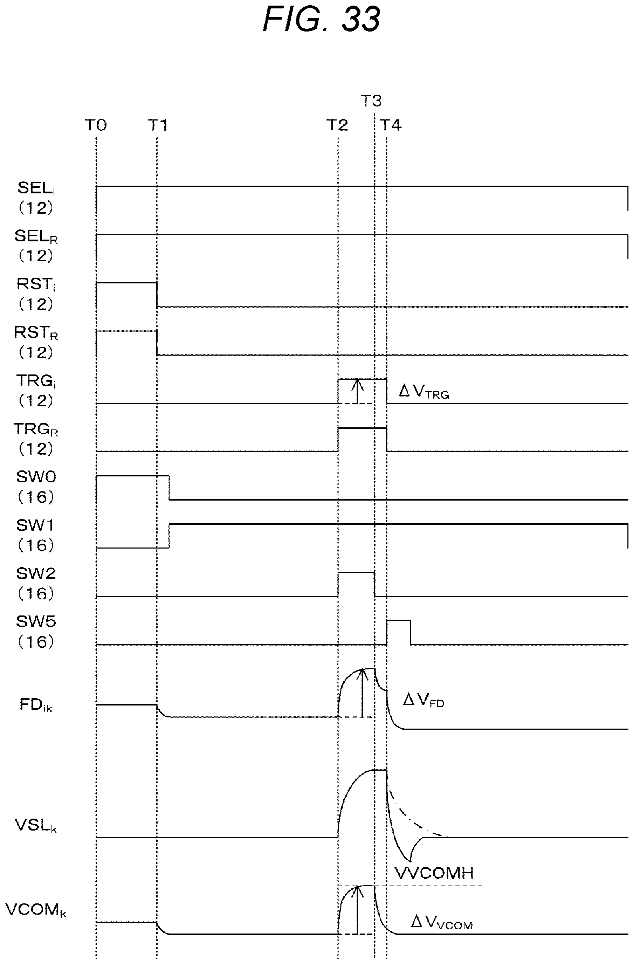

Fig. 33 is a timing chart illustrating an example of a read operation of the CMOS image sensor 10 according to the ninth embodiment of the present technology. The timing chart of the ninth embodiment is different from that of the first embodiment in that the control signal SW5 is further transmitted.

The system control unit 16 sets the control signal SW5 to a high level over a constant pulse period from a timing T4 at the end of a transfer period. Therefore, the switch 324 shifts to a closed state, and a current of the tail current source 323 is further supplied to the vertical current supply line $VCOM_k$. That is, the tail current increases. By increasing the tail current, the settling time until a potential of a vertical signal line $VSL_k$ is stabilized may be shortened. A solid line in the drawing indicates a locus of the potential of the vertical signal line $VSL_k$ when the control signal SW5 is transmitted, and a dashed-dotted line indicates the locus of the potential when the control signal SW5 is not transmitted. By shortening the settling time, a read time may be shortened and a frame rate may be improved.

Note that, each of the second to eighth embodiments may be applied to the ninth embodiment.

As described above, according to the ninth embodiment of the present technology, since the switch 324 increases the tail current immediately after the transfer, the settling time may be shortened. Therefore, the frame rate may be improved.

<10. Tenth Embodiment>

In the first embodiment described above, anodes of the photoelectric conversion element 121 on the reference side and the photoelectric conversion element 131 on the read side are both connected to a ground potential. In this configuration, a potential difference between the voltage of the floating diffusion layer 134 according to the power supply voltage VDD and the anode of the photoelectric conversion element 131 might be insufficient, and the charge transfer efficiency from the photoelectric conversion element 131 to the floating diffusion layer 134 might be deteriorated. A CMOS image sensor 10 of a tenth embodiment is different from that of the first embodiment in that a potential of an anode is made a negative potential and transfer efficiency is improved.

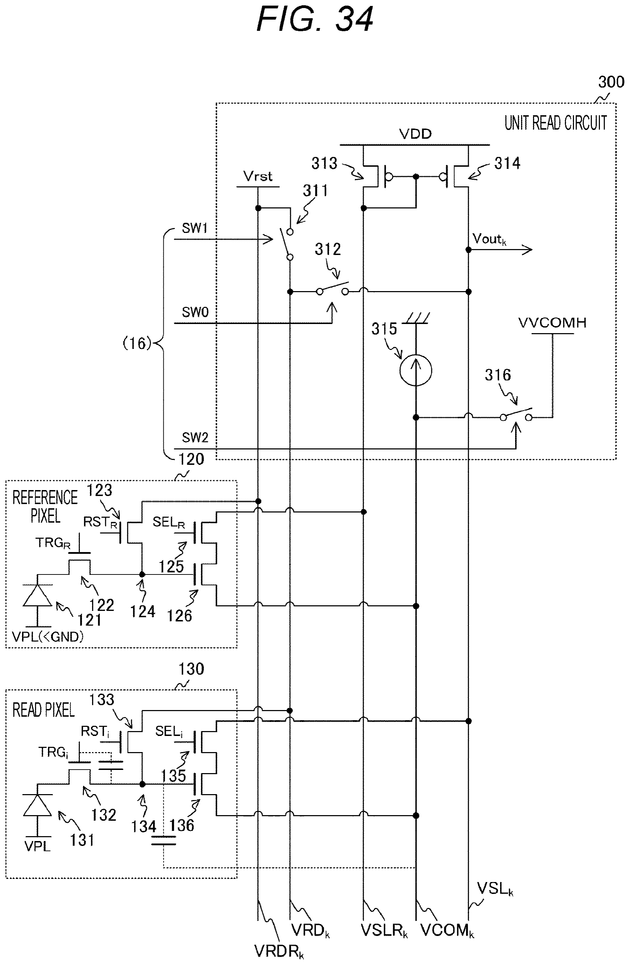

Fig. 34 is a circuit diagram illustrating a configuration example of a reference pixel 120 and a read pixel 130 in the tenth embodiment of the present technology. The reference pixel 120 and the read pixel 130 of the tenth embodiment are different from those of the first embodiment in that anodes of photoelectric conversion elements 121 and 131 are connected to a negative potential VPL lower than a ground potential GND. For example, the ground potential is 0.0 volt (V), and the negative potential VPL is -0.4 volts (V).

The negative potential VPL is a voltage externally supplied through, for example, a terminal (not illustrated) of the CMOS image sensor 10.

By setting the anodes of the photoelectric conversion elements 121 and 131 to the negative potential VPL, the potential difference between the floating diffusion layer 134 and the anode becomes large as compared with a case where the anode is set to the ground potential. Therefore, the transfer efficiency from the photoelectric conversion element 131 to the floating diffusion layer 134 may be improved.

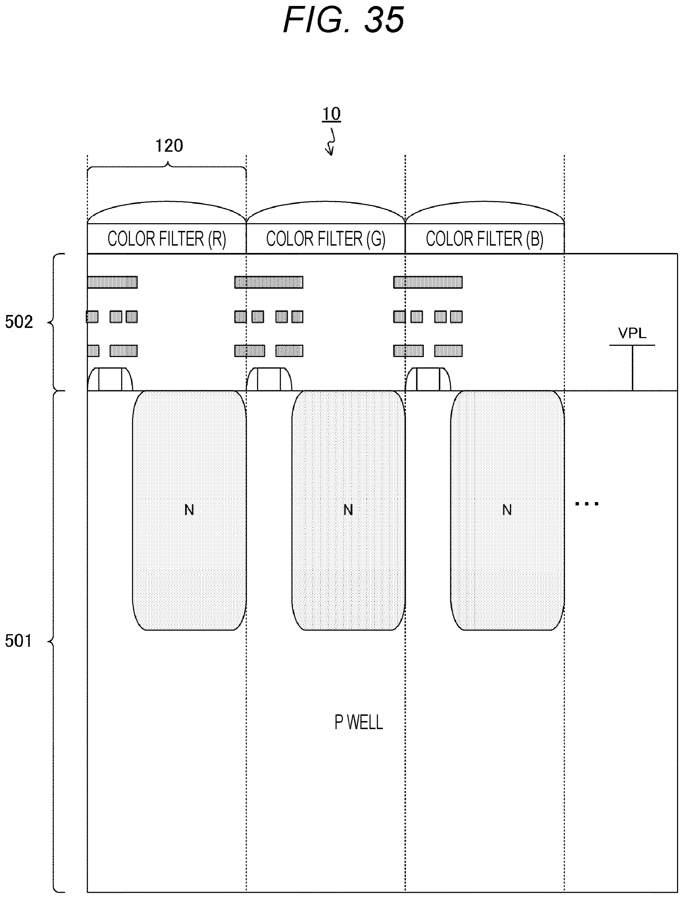

Fig. 35 is an example of a cross-sectional view of the CMOS image sensor 10 according to the tenth embodiment of the present technology. As illustrated in the drawing, a photoelectric conversion layer 501 includes a P well layer and a plurality of N layers provided in the P well layer. Each of the N layers is arranged for each pixel. In contrast, the P well layer is common to all the pixels. The P well layer and the N layer serve as a photoelectric conversion element for each pixel. The potential of the anode of the photoelectric conversion element 121 and the like in the circuit diagram corresponds to a potential of the P well of the pixel. The negative potential VPL is supplied to the P well layer.

As described above, in the tenth embodiment of the present technology, since the P well (anode) of the photoelectric conversion elements 121 and 131 is connected to the negative potential, the potential difference between the floating diffusion layer 134 and the anode becomes larger than that in a case where the anode is set to the ground potential. Therefore, the transfer efficiency from the photoelectric conversion element 131 to the floating diffusion layer 134 may be improved. Note that, each of the second to ninth embodiments may be applied to the tenth embodiment.

<11. Eleventh Embodiment>

In the above-described tenth embodiment, the negative potential VPL is externally supplied through the terminal of the CMOS image sensor 10, but there is a possibility that types of power supplies to be supplied to the CMOS image sensor 10 increases and an external circuit scale increases. A CMOS image sensor 10 of the eleventh embodiment is different from that of the tenth embodiment in that a column read circuit unit 13 supplies a negative potential to each pixel to reduce an external power supply type and a terminal of the CMOS image sensor 10.

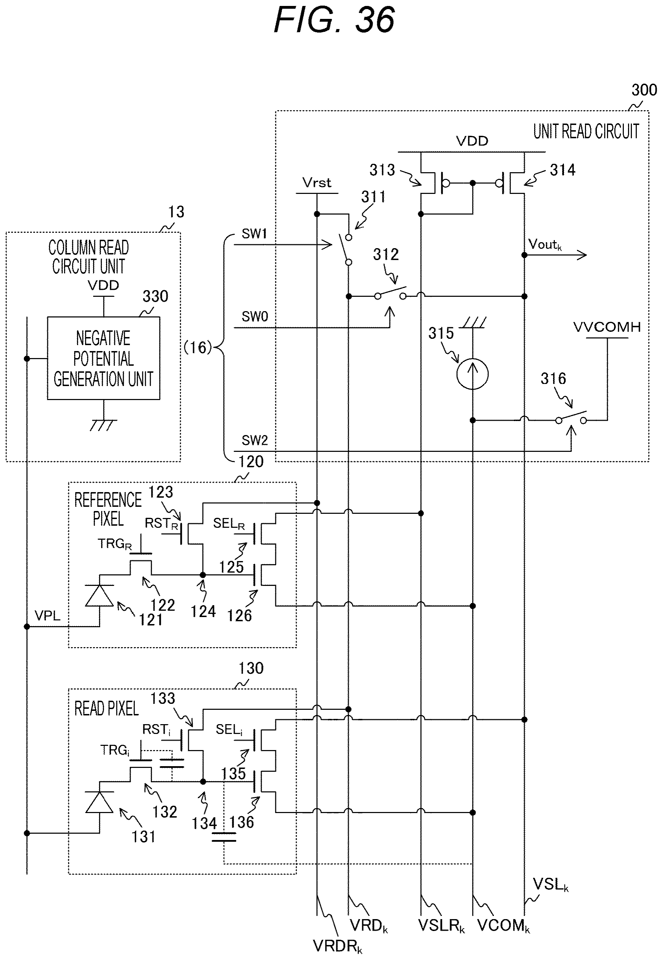

Fig. 36 is a circuit diagram illustrating a configuration example of a column read circuit unit 13, a reference pixel 120, and a read pixel 130 according to the eleventh embodiment of the present technology. The column read circuit unit 13 of the eleventh embodiment is different from that of the tenth embodiment in further including a negative potential generation unit 330 in addition to the unit read circuit 300.

The negative potential generation unit 330 generates a negative potential VPL. The negative potential generation unit 330 supplies the negative potential VPL through a signal line commonly connected to anodes of the reference pixel 120 and the read pixel 130. As the negative potential generation unit 330, for example, a charge pump circuit is used.

As illustrated in the drawing, since the negative potential generation unit 330 in the column read circuit unit 13 supplies the negative potential VPL to each pixel, it is not necessary to externally supply the negative potential VPL through the terminal of the CMOS image sensor 10, and it is possible to reduce the external power supply type and the terminal of the CMOS image sensor 10.

As described above, in the eleventh embodiment of the present technology, since the negative potential generation unit 330 supplies the negative potential VPL to each pixel, it becomes not required to externally supply the negative potential VPL through the terminal of the CMOS image sensor 10. Therefore, the external power supply types and the terminal of the CMOS image sensor 10 may be reduced. Note that, each of the second to ninth embodiments may be applied to the eleventh embodiment.

<12. Twelfth Embodiment>

In the above-described eleventh embodiment, the difference between the signals of a pair of pixels (the reference pixel 120 and the read pixel 130) is amplified by a difference amplifier circuit. In such differential amplifier circuit, a gain for an image signal may be increased and conversion efficiency may be significantly increased as compared with a source follower circuit, but an operation point is narrow and it is difficult to expand a dynamic range. A CMOS image sensor 10 of a twelfth embodiment is different from that of the eleventh embodiment in that a mode forming a differential amplifier circuit and a mode forming a source follower circuit are switched.

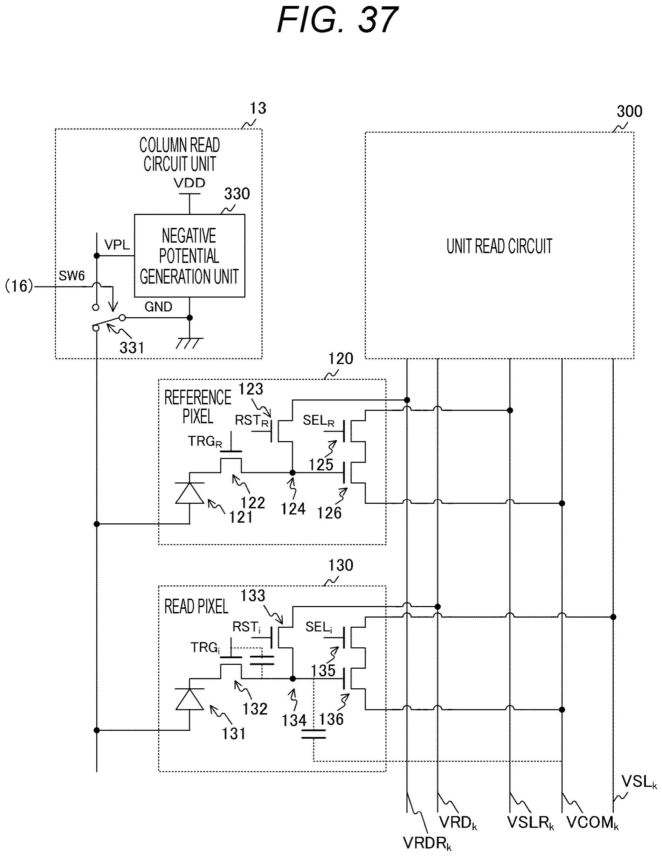

Fig. 37 is a circuit diagram illustrating a configuration example of a column read circuit unit 13, a reference pixel 120, and a read pixel 130 according to the twelfth embodiment of the present technology. The column read circuit unit 13 of the twelfth embodiment is different from that of the eleventh embodiment in that a switch 331 is further provided.

Here, either a differential mode or a source follower (SF) mode is set in the CMOS image sensor 10 according to the twelfth embodiment. The differential mode is a mode in which the reference pixel 120, the read pixel 130, and a unit read circuit 300 form a differential amplifier circuit. In contrast, the SF mode is a mode in which each of the reference pixel 120 and the unit read circuit 300, and the read pixel 130 and the unit read circuit 300 forms a source follower circuit. In the differential mode, a gain for an image signal may be increased and conversion efficiency may be significantly increased as compared with the SF mode, but an operation point is narrow and it is difficult to expand a dynamic range. Therefore, the differential mode is suitable for imaging in a dark place, and the SF mode is suitable for imaging in a bright place. For example, the differential mode is set in a case where a photometric amount of ambient light is smaller than a predetermined threshold, and the SF mode is set in a case where the photometric amount is equal to or larger than the threshold.

For example, in order to enable switching between the differential mode and the SF mode, the switch disclosed in Fig. 19 of Japanese Patent Application Laid-Open No. 2018-182496 is added to the unit read circuit 300, for example. A control timing of the switches is disclosed in Figs. 22 to 24 of Japanese Patent Application Laid-Open No. 2018-182496.

The switch 331 supplies either a negative potential VPL from a negative potential generation unit 330 or a ground potential GND to the anodes of the photoelectric conversion elements 121 and 131 according to a control signal SW6 from a system control unit 16. In a case where the differential mode is set, the system control unit 16 supplies the negative potential VPL by the control signal SW6. Then, the unit read circuit 300 outputs a signal obtained by amplifying a difference between voltages of floating diffusion layers 124 and 134. In contrast, in a case where the SF mode is set, the system control unit 16 supplies the ground potential GND by the control signal SW6. Then, the unit read circuit 300 sequentially outputs a signal obtained by amplifying the voltage of the floating diffusion layer 124 and a signal obtained by amplifying the voltage of the floating diffusion layer 134.

Since the switch 331 supplies the negative potential VPL in the differential mode used in the dark place, charge transfer efficiency may be improved as compared with the SF mode. Therefore, even in a case where a charge amount is small in the dark place, it is possible to suppress deterioration in image quality by improving the transfer efficiency.

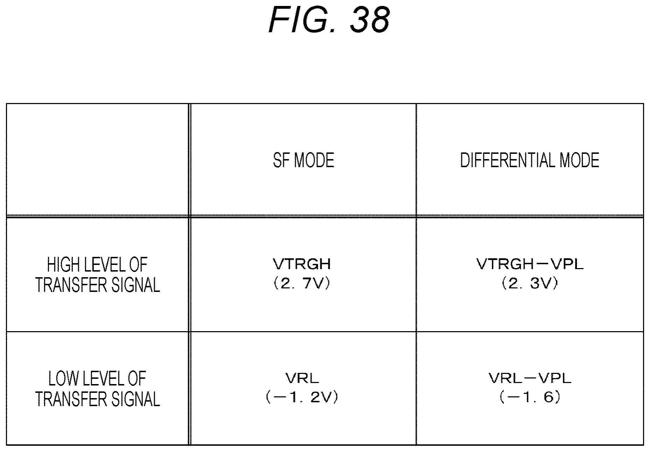

Fig. 38 is a view illustrating a set example of a level of a transfer signal in the twelfth embodiment of the present technology. In a case where the differential mode is set, a vertical drive unit 12 of the twelfth embodiment supplies a transfer signal at a lower level than that in a case where the SF mode is set to transfer transistors 122 and 132 according to a potential decrease of the anode of the photoelectric conversion element.

In the SF mode, the vertical drive unit 12 supplies a transfer signal a high level of which is VTRGH and a low level of which is VRL. In contrast, in the differential mode, the vertical drive unit 12 supplies a transfer signal a high level of which is VTRGH-VPL and a low level of which is VRL-VPL. For example, it is assumed that VTRGH is 2.7 volts (V), VRL is - 1.2 volts (V), and VPL is 0.4 volts (V). In this case, in the differential mode, a transfer signal a high level of which is 2.3 volts (V) and a low level of which is -1.6 volts (V) is supplied. As described above, since the level of the transfer signal is also lowered in the differential mode, a breakdown voltage of a gate oxide film of the transistor corresponding to transfer signals $TRG_R$ and $TRG_i$ may be made similar to that in the SF mode and avoid an influence on reliability.

As described above, according to the twelfth embodiment of the present technology, since the negative potential generation unit 330 supplies the negative potential VPL to the photoelectric conversion elements 121 and 131 in a case where the differential mode is set, the breakdown voltage of the gate oxide film of the transistor corresponding to the transfer signals $TRG_R$ and $TRG_i$ may be made similar to that in the SF mode and avoid an influence on reliability. Note that, each of the second to eleventh embodiments may be applied to the twelfth embodiment.

## <13. Thirteenth Embodiment>

In the first embodiment described above, the column read circuit unit 13 outputs the signals from the vertical signal lines $VSL_k$ and $VSLR_k$, but it is desirable to shield these vertical signal lines from a viewpoint of reducing noise. A CMOS image sensor 10 of a thirteenth embodiment is different from that of the first embodiment in that a vertical signal line is covered with a shield line.

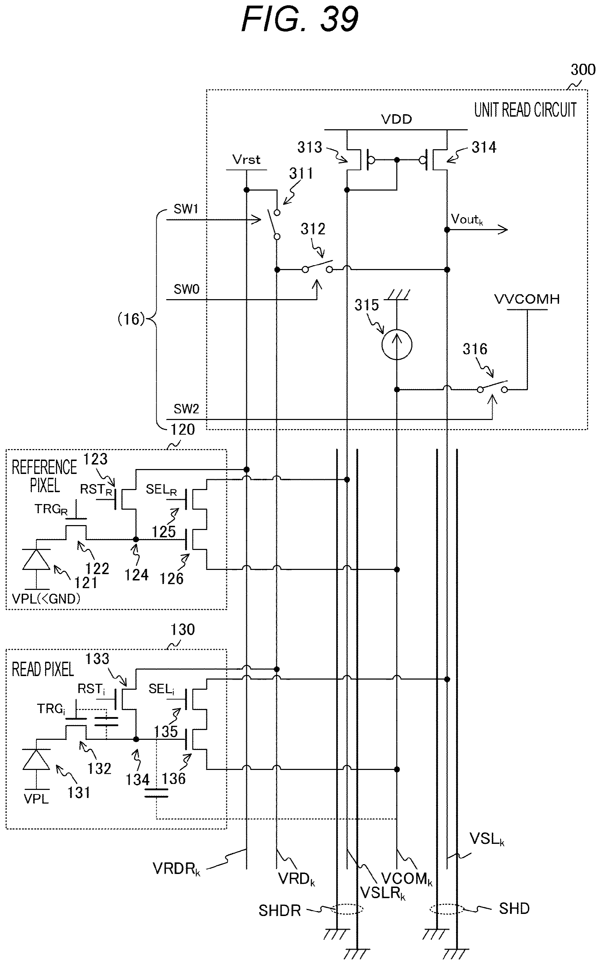

Fig. 39 is a circuit diagram illustrating a configuration example of a pixel array unit 11 in the thirteenth embodiment of the present technology. In the pixel array unit 11 of the thirteenth embodiment, vertical signal lines $VSL_k$ and $VSLR_k$ are covered with shield lines SHD and SHDR, respectively. These shield lines are connected to a ground potential. With these shield lines, noise of signals transmitted through the vertical signal lines $VSL_k$ and $VSLR_k$ may be reduced.

As described above, according to the thirteenth embodiment of the present technology, since the vertical signal lines $VSL_k$ and $VSLR_k$ are covered with the shield lines SHD and SHDR, respectively, the noise of the signals transmitted through these vertical signal lines may be reduced.

## <14. Variation>

(Configuration of Stacked Type)

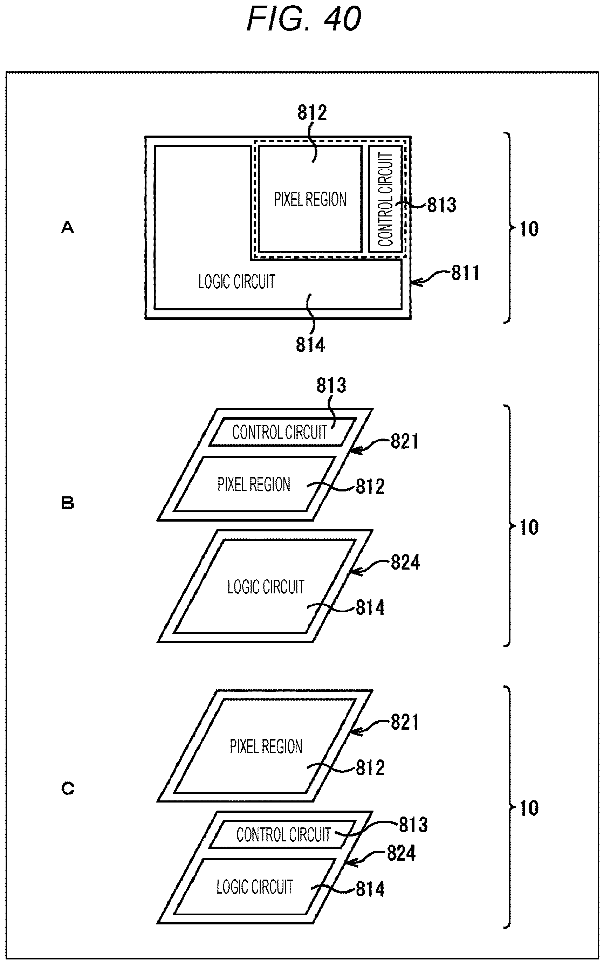

Fig. 40 is a view illustrating a configuration example of a stacked solid-state imaging device to which the present technology is applicable.

A of Fig. 40 illustrates a schematic configuration example of a non-stacked solid-state imaging device. As illustrated in A of Fig. 40, a CMOS image sensor 10 includes one die (semiconductor substrate) 811. The die 811 is equipped with a pixel region 812 in which pixels are two-dimensionally arranged, a control circuit 813 that drives the pixels and performs other various controls, and a logic circuit 814 for performing signal processing.

B of Fig. 40 and C of Fig. 40 illustrate schematic configuration examples of the stacked solid-state imaging device. As illustrated in B of Fig. 40 and C of Fig. 40, the CMOS image sensor 10 is configured as one semiconductor chip by stacking and electrically connecting two dies of a sensor die 821 and a logic die 824.

In B of Fig. 40, the sensor die 821 is equipped with a pixel region 812 and a control circuit 813, and the logic die 824 is equipped with a logic circuit 814 including a signal processing circuit that performs signal processing.

In C of Fig. 40, the sensor die 821 is equipped with the pixel region 812, and the logic die 824 is equipped with the control circuit 813 and the logic circuit 814.

(Configuration of signal processing device)

In the above description, the solid-state imaging device such as the CMOS image sensor 10 is described as an example, but the present technology is not limited to the solid-state imaging device, and may be applied to a signal processing device that performs various types of signal processing. Note that, in the read pixel 130 and the reference pixel 120, the floating diffusion layer 134 and the floating diffusion layer 124 as the floating diffusion (FD) may also be a sample hold circuit. That is, the amplification transistor 136 on the read side is provided according to each input signal from a plurality of input channels and amplifies the input signal input through the sample hold circuit, and the amplification transistor 126 on the reference side is paired with each of the amplification transistors 136 on the read side.

## <15. Configuration of Electronic Device>

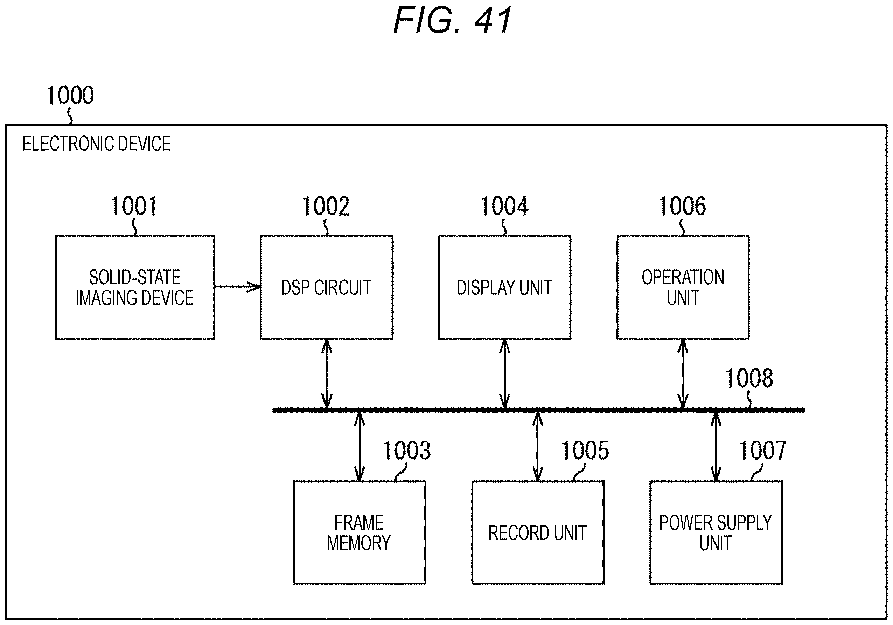

Fig. 41 is a block diagram illustrating a configuration example of an electronic device including a solid-state imaging device to which the present technology is applied. An electronic device 1000 is an electronic device such as an imaging device such as a digital still camera and a video camera, a portable terminal device such as a smartphone and a tablet terminal and the like, for example.

The electronic device 1000 includes a solid-state imaging device 1001, a DSP circuit 1002, a frame memory 1003, a display unit 1004, a record unit 1005, an operation unit 1006, and a power supply unit 1007. Furthermore, in the electronic device 1000, the DSP circuit 1002, the frame memory 1003, the display unit 1004, the record unit 1005, the operation unit 1006, and the power supply unit 1007 are connected to one another through a bus line 1008.

The solid-state imaging device 1001 corresponds to the CMOS image sensor 10 described above, and differential amplification reading and source follower reading are performed on a plurality of pixels two-dimensionally arranged in the pixel array unit 11.

Here, at the time of differential amplification reading, a reset voltage of a reference pixel may be externally applied, and a reset voltage of a read pixel may be configured such that negative feedback is applied from a vertical signal line. Furthermore, at the time of differential amplification reading, it is possible to connect (connect) a source side and a drain side or nodes on both the source side and the drain side of an amplification transistor of the reference pixel between columns of a pixel array unit.

The DSP circuit 1002 is a camera signal processing circuit that processes a signal supplied from the solid-state imaging device 1001. The DSP circuit 1002 outputs image data obtained by processing the signal from the solid-state imaging device 1001. The frame memory 1003 temporarily holds image data processed by the DSP circuit 1002 in a frame unit.

The display unit 1004 including a panel display device such as a liquid crystal panel and an organic electro luminescence (EL) panel, for example, displays a moving image or a still image taken by the solid-state imaging device 1001. The record unit 1005 records image data of the moving image or the still image taken by the solid-state imaging device 1001 in a recording medium such as a semiconductor memory and a hard disk.

The operation unit 1006 outputs an operation instruction regarding various functions of the electronic device 1000 according to an operation by a user. The power supply unit 1007 appropriately supplies various power sources serving as operation power sources of the DSP circuit 1002, the frame memory 1003, the display unit 1004, the record unit 1005, and the operation unit 1006 to supply targets.

The electronic device 1000 is configured in the above-described manner. As described above, the present technology is applied to the solid-state imaging device 1001. Specifically, the CMOS image sensor 10 may be applied to the solid-state imaging device 1001.

By applying the present technology to the solid-state imaging device 1001, at the time of differential amplification reading, the reset voltage of the reference pixel may be externally applied, and the reset voltage of the read pixel may be configured such that negative feedback is applied from the vertical signal line. Therefore, it is possible to control a potential of a floating diffusion region of the read pixel at the time of reset to a desired value in addition to suppressing deviation of a reset level from a readable range by reset feedthrough while realizing high conversion efficiency (amplification factor) by the differential amplification reading.

Furthermore, by applying the present technology to the solid-state imaging device 1001, at the time of differential amplification reading, it is possible to connect (connect) the source side and the drain side or the nodes on both the source side and the drain side of the amplification transistor of the reference pixel between the columns of the pixel array unit. Therefore, it is possible to suppress an increase in noise while realizing the high conversion efficiency (amplification factor) by the differential amplification reading.

<16. Usage Example of Solid-State Imaging Device>

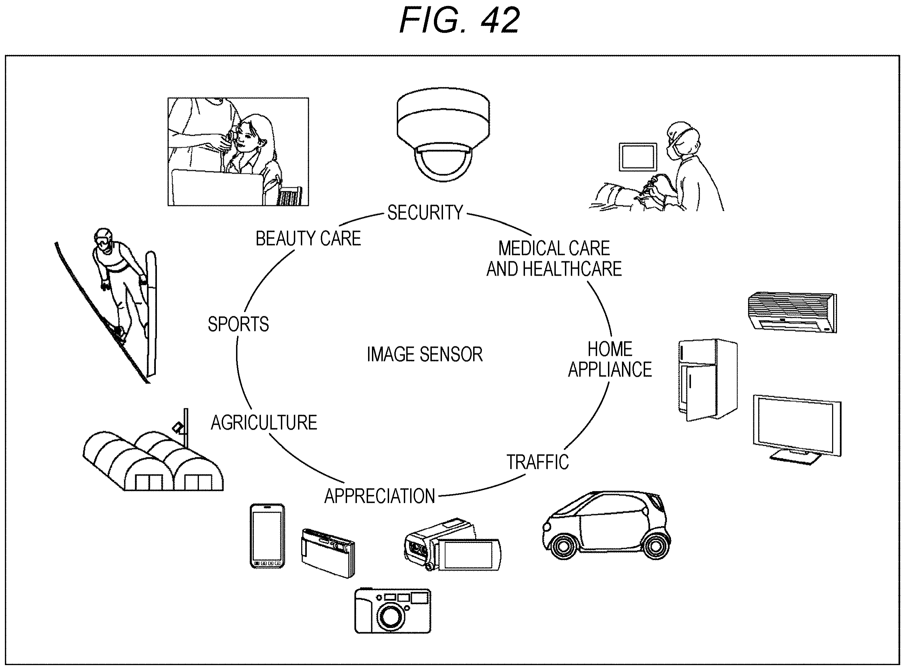

Fig. 42 is a view illustrating a usage example of a solid-state imaging device to which the present technology is applied.

The CMOS image sensor 10 may be used in various cases in which light such as visible light, infrared light, ultraviolet light, and X-ray is sensed as hereinafter described, for example. That is, as illustrated in Fig. 42, the CMOS image sensor 10 may also be used in devices used in a traffic field, a home appliance field, a medical care and health care field, a security field, a beauty care field, a sports field, or an agricultural field, for example, in addition to a field of appreciation in which an image to be appreciated is taken.

Specifically, the CMOS image sensor 10 may be used in a device for taking an image to be appreciated (electronic device 1000 in Fig. 41, for example) such as a digital camera, a smartphone, and a portable phone having a camera function, for example, in the field of appreciation.

In the traffic field, the CMOS image sensor 10 may be used in devices used for traffic such as an in-vehicle sensor that takes images of the front, back, surroundings, and inside of an automobile, a monitoring camera that monitors running vehicles and roads, and a ranging sensor that measures a distance between vehicles for safe driving such as automatic stop and recognition of a driver's condition, for example.

In the home appliance field, the CMOS image sensor 10 may be used in home appliances such as a television receiver, a refrigerator, and an air conditioner for taking an image of a user's gesture and operating the device according to the gesture, for example. Furthermore, in the medical care and health care field, the CMOS image sensor 10 may be used in medical care and health care devices such as an endoscope and a device performing angiography by receiving infrared light, for example.

In the security field, the CMOS image sensor 10 may be used in security devices such as a security monitoring camera and a personal authentication camera, for example. Furthermore, in the beauty care field, the CMOS image sensor 10 may be used in beauty care devices such as a skin measuring device that takes an image of skin and a microscope that takes an image of scalp, for example.

In the sports field, the CMOS image sensor 10 may be used in sports devices such as an action camera and a wearable camera for sports, for example. Furthermore, in the agricultural field, the CMOS image sensor 10 may be used in agricultural devices such as a camera for monitoring a land and crop state, for example.

<17. Application Example to Mobile Body>

The technology according to the present disclosure (present technology) may be applied to various products. For example, the technology according to the present disclosure may also be realized as a device mounted on any type of mobile body such as an automobile, an electric automobile, a hybrid electric automobile, a motorcycle, a bicycle, a personal mobility, an airplane, a drone, a ship, and a robot.

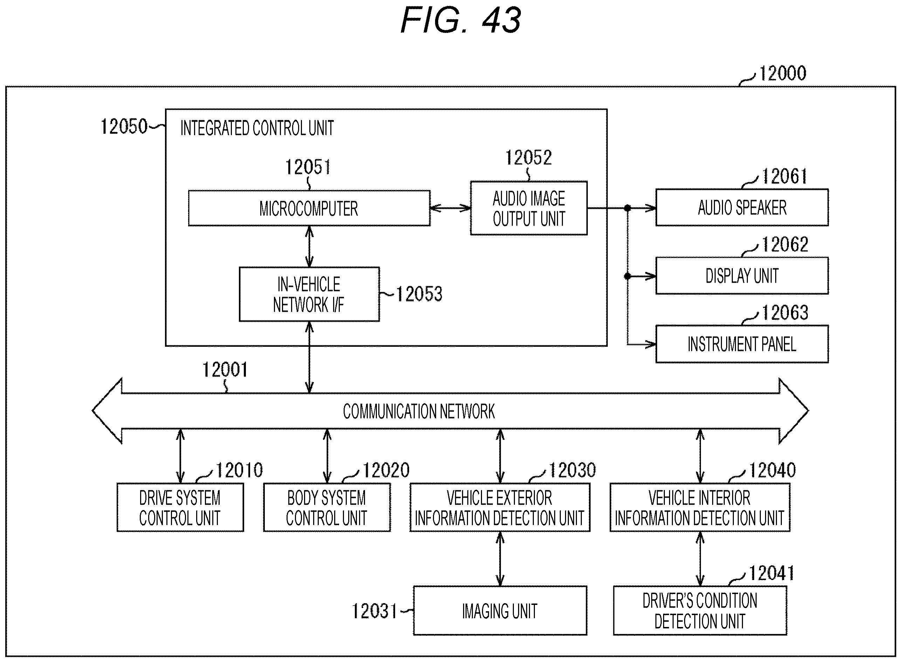

Fig. 43 is a block diagram illustrating a schematic configuration example of a vehicle control system that is an example of a mobile body control system to which the technology according to the present disclosure may be applied.

A vehicle control system 12000 is provided with a plurality of electronic control units connected to one another through a communication network 12001. In the example illustrated in Fig. 43, the vehicle control system 12000 is provided with a drive system control unit 12010, a body system control unit 12020, a vehicle exterior information detection unit 12030, a vehicle interior information detection unit 12040, and an integrated control unit 12050. Furthermore, a microcomputer 12051, an audio image output unit 12052, and an in-vehicle network interface (I/F) 12053 are illustrated as functional configurations of the integrated control unit 12050.

The drive system control unit 12010 controls operations of devices related to a drive system of a vehicle according to various programs. For example, the drive system control unit 12010 serves as a control device of a driving force generating device for generating driving force of the vehicle such as an internal combustion engine or a driving motor, a driving force transmitting mechanism for transmitting the driving force to wheels, a steering mechanism for adjusting a rudder angle of the vehicle, a braking device for generating braking force of the vehicle and the like.

The body system control unit 12020 controls operations of various devices mounted on a vehicle body according to the various programs. For example, the body system control unit 12020 serves as a control device of a keyless entry system, a smart key system, a power window device, or various lights such as a head light, a backing light, a brake light, a blinker, or a fog light. In this case, a radio wave transmitted from a portable device that substitutes for a key or signals of various switches may be input to the body system control unit 12020. The body system control unit 12020 receives an input of the radio wave or signals and controls a door lock device, a power window device, the lights and the like of the vehicle.

The vehicle exterior information detection unit 12030 detects information outside the vehicle equipped with the vehicle control system 12000. For example, an imaging unit 12031 is connected to the vehicle exterior information detection unit 12030. The vehicle exterior information detection unit 12030 allows the imaging unit 12031 to take an image outside the vehicle and receives the taken image. The vehicle exterior information detection unit 12030 may perform detection processing of objects such as a person, a vehicle, an obstacle, a sign, or a character on a road surface or distance detection processing on the basis of the received image.

The imaging unit 12031 is an optical sensor that receives light and outputs an electric signal corresponding to an amount of the received light. The imaging unit 12031 may output the electric signal as the image or output the same as ranging information. Furthermore, the light received by the imaging unit 12031 may be visible light or invisible light such as infrared light.

The vehicle interior information detection unit 12040 detects information in the vehicle. The vehicle interior information detection unit 12040 is connected to, for example, a driver's condition detection unit 12041 that detects a driver's condition. The driver's condition detection unit 12041 includes, for example, a camera that images the driver, and the vehicle interior information detection unit 12040 may calculate a driver's fatigue level or concentration level or may determine whether or not the driver is dozing on the basis of detection information input from the driver's condition detection unit 12041.

The microcomputer 12051 may perform an arithmetic operation of a control target value of the driving force generating device, the steering mechanism, or the braking device on the basis of the information inside and outside the vehicle obtained by the vehicle exterior information detection unit 12030 or the vehicle interior information detection unit 12040, and output a control instruction to the drive system control unit 12010. For example, the microcomputer 12051 may perform cooperative control for realizing functions of advanced driver assistance system (ADAS) including collision avoidance or impact attenuation of the vehicle, following travel based on the distance between the vehicles, vehicle speed maintaining travel, vehicle collision warning, vehicle lane departure warning or the like.

Furthermore, the microcomputer 12051 may perform the cooperative control for realizing automatic driving and the like to autonomously travel independent from the operation of the driver by controlling the driving force generating device, the steering mechanism, the braking device or the like on the basis of the information around the vehicle obtained by the vehicle exterior information detection unit 12030 or the vehicle interior information detection unit 12040.

Furthermore, the microcomputer 12051 may output the control instruction to the body system control unit 12020 on the basis of the information outside the vehicle obtained by the vehicle exterior information detection unit 12030. For example, the microcomputer 12051 may perform the cooperative control to realize glare protection such as controlling the head light according to a position of a preceding vehicle or an oncoming vehicle detected by the vehicle exterior information detection unit 12030 to switch a high beam to a low beam.

The audio image output unit 12052 transmits at least one of audio or image output signal to an output device capable of visually or audibly notifying an occupant of the vehicle or the outside the vehicle of the information. In the example in Fig. 43, as the output device, an audio speaker 12061, a display unit 12062, and an instrument panel 12063 are illustrated. The display unit 12062 may include at least one of an on-board display or a head-up display, for example.

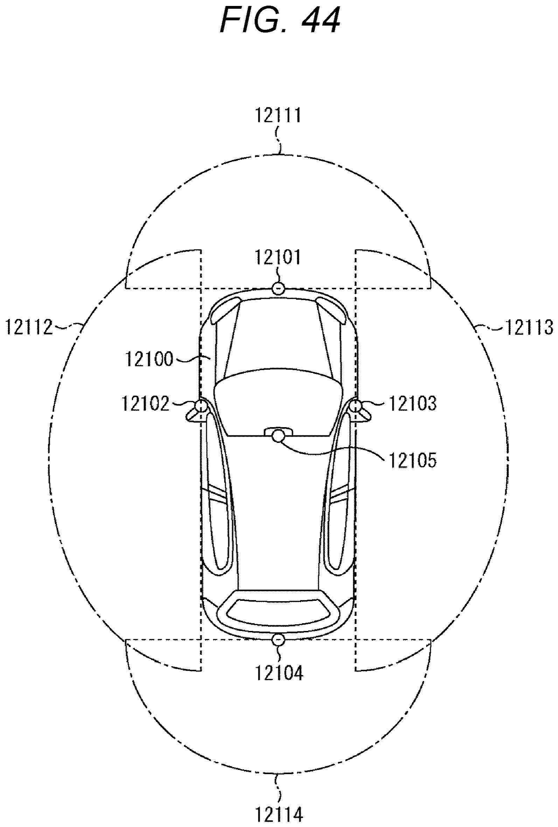

Fig. 44 is a view illustrating an example of an installation position of the imaging unit 12031.

In Fig. 44, imaging units 12101, 12102, 12103, 12104, and 12105 are included as the imaging unit 12031.

The imaging units 12101, 12102, 12103, 12104, and 12105 are provided in positions such as, for example, a front nose, a side mirror, a rear bumper, a rear door, and an upper portion of a front windshield in a vehicle interior of the vehicle 12100. The imaging unit 12101 provided on the front nose and the imaging unit 12105 provided in the upper portion of the front windshield in the vehicle interior principally obtain images in front of the vehicle 12100. The imaging units 12102 and 12103 provided on the side mirrors principally obtain images of the sides of the vehicle 12100. The imaging unit 12104 provided on the rear bumper or the rear door principally obtains an image behind the vehicle 12100. The imaging unit 12105 provided in the upper portion of the front windshield in the vehicle interior is principally used for detecting the preceding vehicle, a pedestrian, an obstacle, a traffic signal, a traffic sign, a lane or the like.

Note that, in Fig. 44, an example of imaging ranges of the imaging units 12101 to 12104 is illustrated. An imaging range 12111 indicates the imaging range of the imaging unit 12101 provided on the front nose, imaging ranges 12112 and 12113 indicate the imaging ranges of the imaging units 12102 and 12103 provided on the side mirrors, and an imaging range 12114 indicates the imaging range of the imaging unit 12104 provided on the rear bumper or the rear door. For example, image data imaged by the imaging units 12101 to 12104 are superimposed, so that an overlooking image of the vehicle 12100 as seen from above is obtained.

At least one of the imaging units 12101 to 12104 may have a function of obtaining distance information. For example, at least one of the imaging units 12101 to 12104 may be a stereo camera including a plurality of imaging elements, or may be an imaging element including pixels for phase difference detection.

For example, the microcomputer 12051 may extract especially a closest solid object on a traveling path of the vehicle 12100, the solid object traveling at a predetermined speed (for example, 0 km/h or higher) in a direction substantially the same as that of the vehicle 12100 as the preceding vehicle by obtaining a distance to each solid object in the imaging ranges 12111 to 12114 and a change in time of the distance (relative speed relative to the vehicle 12100) on the basis of the distance information obtained from the imaging units 12101 to 12104. Moreover, the microcomputer 12051 may set the distance between the vehicles to be secured in advance from the preceding vehicle, and may perform automatic brake control (including following stop control), automatic acceleration control (including following start control) and the like. As described above, it is possible to perform the cooperative control for realizing the automatic driving and the like to autonomously travel independent from the operation of the driver.

For example, the microcomputer 12051 may extract solid object data regarding the solid object while sorting the same into a motorcycle, a standard vehicle, a large-sized vehicle, a pedestrian, and other solid objects such as a utility pole on the basis of the distance information obtained from the imaging units 12101 to 12104 and use for automatically avoiding obstacles. For example, the microcomputer 12051 discriminates the obstacles around the vehicle 12100 into an obstacle visible to a driver of the vehicle 12100 and an obstacle difficult to see. Then, the microcomputer 12051 determines a collision risk indicating a degree of risk of collision with each obstacle, and when the collision risk is equal to or higher than a set value and there is a possibility of collision, this may perform driving assistance for avoiding the collision by outputting an alarm to the driver through the audio speaker 12061 and the display unit 12062 or performing forced deceleration or avoidance steering through the drive system control unit 12010.

At least one of the imaging units 12101 to 12104 may be an infrared camera that detects infrared light. For example, the microcomputer 12051 may recognize a pedestrian by determining whether or not there is a pedestrian in the images taken by the imaging units 12101 to 12104. Such pedestrian recognition is carried out, for example, by a procedure of extracting feature points in the images taken by the imaging units 12101 to 12104 as the infrared cameras, and a procedure of performing pattern matching processing on a series of feature points indicating an outline of an object to discriminate whether or not this is a pedestrian. When the microcomputer 12051 determines that there is a pedestrian in the images taken by the imaging units 12101 to 12104 and recognizes the pedestrian, the audio image output unit 12052 controls the display unit 12062 to superimpose a rectangular contour for emphasis on the recognized pedestrian to display. Furthermore, the audio image output unit 12052 may control the display unit 12062 to display an icon and the like indicating the pedestrian in a desired position.

An example of the vehicle control system to which the technology according to the present disclosure may be applied is described above. The technology according to the present disclosure may be applied to the imaging unit 12031, for example, out of the configurations described above. Specifically, the CMOS image sensor 10 in Fig. 1 may be applied to the imaging unit 12031. By applying the technology according to the present disclosure to the imaging unit 12031, the charge transfer efficiency may be improved, and a more easily viewable taken image may be obtained even under low illuminance, so that driver's fatigue may be reduced.

Note that the above-described embodiment describes an example of embodying the present technology, and there is a correspondence relationship between items in the embodiment and the matters specifying the invention in claims. Similarly, there is a correspondence relationship between the matters specifying the invention in claims and the matters in the embodiment of the present technology having the same names. However, the present technology is not limited to the embodiment and may be embodied by variously modifying the embodiment without departing from the gist thereof.

Note that the present technology may also have a following configuration.

(1) A solid-state imaging device provided with:

a transfer transistor that transfers a charge from a photoelectric conversion element to a floating diffusion layer in a predetermined transfer period according to a transfer signal transmitted through a predetermined transfer line; and
a potential control unit that makes a potential in the transfer period of a predetermined signal line capacitively coupled to the floating diffusion layer higher than the potential outside the transfer period.

(2) The solid-state imaging device according to (1) described above, in which

the transfer transistor includes a reference side transfer transistor arranged in a reference pixel and a read side transfer transistor arranged in a read pixel, and
the reference pixel is further provided with:

a reference side reset transistor that initializes the floating diffusion layer in the reference pixel according to a predetermined reset signal;
a reference side amplification transistor that amplifies a voltage of the floating diffusion layer in the reference pixel; and
a reference side selection transistor that outputs a signal corresponding to the voltage amplified by the reference side amplification transistor according to a predetermined selection signal, and
the read pixel is further provided with:

a read side reset transistor that initializes the floating diffusion layer in the read pixel according to a predetermined reset signal;
a read side amplification transistor that amplifies a voltage of the floating diffusion layer in the read pixel; and
a read side selection transistor that outputs a signal corresponding to the voltage amplified by the read side amplification transistor according to a predetermined selection signal.

(3) The solid-state imaging device according to (2) described above, further provided with:

a tail current source that supplies a current to a vertical current supply line commonly connected to the reference side amplification transistor and the read side amplification transistor, in which
the predetermined signal line includes the vertical current supply line.

(4) The solid-state imaging device according to (3) described above, in which
the potential control unit is provided with a switch that makes a potential of the vertical current supply line in the transfer period higher than the potential outside the transfer period.

(5) The solid-state imaging device according to (3) described above, in which

the read side selection transistor outputs the signal through a vertical signal line, and
the potential control unit is provided with a switch that connects the vertical current supply line to the vertical signal line in the transfer period.

(6) The solid-state imaging device according to any one of (2) to (5) described above, in which

the predetermined signal line includes a vertical signal line that transmits the signal from the read side selection

EP 3 941 033 A1

transistor, and
the potential control unit is provided with a switch that makes a potential of the vertical signal line in the transfer period higher than the potential outside the transfer period.

(7) The solid-state imaging device according to any one of (2) to (6) described above, in which

the predetermined signal line includes a potential fluctuation dedicated line, and
the potential control unit is provided with a driver that makes a potential of the potential fluctuation dedicated line in the transfer period higher than the potential outside the transfer period.

(8) The solid-state imaging device according to (7) described above, in which
the potential fluctuation dedicated line is wired in a horizontal direction.
(9) The solid-state imaging device according to (7) described above, in which
the potential fluctuation dedicated line is wired in a vertical direction.
(10) The solid-state imaging device according to any one of (2) to (9) described above, in which

the read pixel is further provided with a conversion efficiency control transistor that controls conversion efficiency of conversion of the charge into the voltage, and
the predetermined signal line includes a control line connected to a gate of the conversion efficiency control transistor.

(11) The solid-state imaging device according to any one of (2) to (10) described above, in which
an amplitude of the reset signal to the read side reset transistor and an amplitude of the reset signal to the reference side reset transistor are different from each other.
(12) The solid-state imaging device according to any one of (2) to (11) described above, further provided with:

a driver that controls a potential of the transfer signal to any one of a predetermined low level, a middle level higher than the low level, and a high level higher than the middle level, in which
the driver causes transition of the potential of the transfer signal from the high level to the middle level in the transfer period.

(13) The solid-state imaging device according to any one of (2) to (12) described above, further provided with:
a current amount control unit that increases a current amount of a tail current supplied to the reference side amplification transistor and the read side amplification transistor over a predetermined period from when the transfer period ends.
(14) The solid-state imaging device according to any one of (1) to (13) described above, in which

a wiring layer is arranged between a microlens and the photoelectric conversion element on a predetermined semiconductor substrate, and
the transfer transistor is arranged in the wiring layer.

(15) The solid-state imaging device according to any one of (1) to (13) described above, in which

the photoelectric conversion element is arranged between a microlens and a wiring layer on a predetermined semiconductor substrate, and
the transfer transistor is arranged in the wiring layer.

(16) A solid-state imaging device provided with:

a reference pixel provided with a predetermined wire; and
a read pixel provided with a wire having a shape different from a shape of the wire of the reference pixel.

(17) The solid-state imaging device according to (16) described above, in which

in a horizontal direction perpendicular to a vertical signal line in a predetermined wiring layer,
a length of a portion where a wire connected to a reference side reset transistor in the reference pixel and a wire that connects a reference side amplification transistor to a reference side floating diffusion layer are closest is shorter than a length of a portion where a wire connected to a read side reset transistor in the read pixel and a wire that connects a read side amplification transistor to a read side floating diffusion layer are closest.

(18) A solid-state imaging device provided with:

a read side photoelectric conversion element connected to a predetermined negative potential lower than a predetermined ground potential;

a read side transfer transistor that transfers a charge from the read side photoelectric conversion element to a read side floating diffusion layer;

a reference side photoelectric conversion element connected to the negative potential;

a reference side transfer transistor that transfers a charge from the reference side photoelectric conversion element to a reference side floating diffusion layer; and

a column read circuit unit provided with a tail current source connected to the ground potential that outputs, as a pixel signal, a signal obtained by amplifying a difference between a voltage of the read side floating diffusion layer and a voltage of the reference side floating diffusion layer.

(19) The solid-state imaging device according to (18) described above, in which
the column read circuit unit is further provided with a negative potential generation unit that generates the negative potential.

(20) The solid-state imaging device according to (19) described above, in which

the column read circuit unit is further provided with a switch that supplies either the negative potential or the ground potential to the read side photoelectric conversion element and the reference side photoelectric conversion element, and

the column read circuit unit amplifies the difference in a case where a predetermined differential mode is set, and outputs each of a signal obtained by amplifying the voltage of the read side floating diffusion layer and a signal obtained by amplifying the voltage of the reference side floating diffusion layer in a case where a predetermined source follower mode is set, and

the switch supplies the negative potential in a case where the differential mode is set, and supplies the ground potential in a case where the source follower mode is set.

(21) The solid-state imaging device according to (20) described above, further provided with:

a vertical drive unit that supplies a transfer signal to each of the read side transfer transistor and the reference side transfer transistor, in which

the vertical drive unit supplies the transfer signal at a lower level than a level in the source follower mode in a case where the differential mode is set.

(22) The solid-state imaging device according to any one of (18) to (21) described above, in which

the column read circuit unit outputs a signal obtained by amplifying the difference through a vertical signal line, and a shield line that covers the vertical signal line is connected to the ground potential.

(23) An electronic device provided with:

a transfer transistor that transfers a charge from a photoelectric conversion element to a floating diffusion layer in a predetermined transfer period according to a transfer signal transmitted through a predetermined transfer line;

a potential control unit that makes a potential in the transfer period of a predetermined signal line capacitively coupled to the floating diffusion layer higher than the potential outside the transfer period; and

a signal processing unit that processes a pixel signal corresponding to a voltage of the floating diffusion layer.

(24) A control method of a solid-state imaging device provided with:

a transfer procedure that transfers a charge from a photoelectric conversion element to a floating diffusion layer in a predetermined transfer period according to a transfer signal transmitted through a predetermined transfer line; and

a potential control procedure that makes a potential in the transfer period of a predetermined signal line capacitively coupled to the floating diffusion layer higher than the potential outside the transfer period.

REFERENCE SIGNS LIST

10 CMOS image sensor
11 Pixel array unit
12 Vertical drive unit
13 Column read circuit unit
14 Column signal processing unit
15 Horizontal drive unit
16 System control unit
17 Signal processing unit
18 Data storage unit
31 Pixel drive line
32 Vertical pixel wire
111 Reference pixel region
112 Read pixel region
120 Reference pixel
121, 131 Photoelectric conversion element
122, 132 Transfer transistor
123, 133 Reset transistor
124, 134 Floating diffusion layer
125, 135 Selection transistor
126, 136 Amplification transistor
127, 137 Conversion efficiency control transistor
130 Read pixel
210 Driver control unit
221 to 230, 320, 321 Driver
300 Unit read circuit
311, 312, 316, 317, 318, 324, 331 Switch
313, 314 pMOS transistor
315, 323 Tail current source
330 Negative potential generation unit
501 Photoelectric conversion layer
502 Wiring layer
12031 Imaging unit

**Claims**

1.  A solid-state imaging device comprising:

    a transfer transistor that transfers a charge from a photoelectric conversion element to a floating diffusion layer in a predetermined transfer period according to a transfer signal transmitted through a predetermined transfer line; and
    a potential control unit that makes a potential in the transfer period of a predetermined signal line capacitively coupled to the floating diffusion layer higher than the potential outside the transfer period.

2.  The solid-state imaging device according to claim 1, wherein

    the transfer transistor includes a reference side transfer transistor arranged in a reference pixel and a read side transfer transistor arranged in a read pixel, and
    the reference pixel is further provided with:

    a reference side reset transistor that initializes the floating diffusion layer in the reference pixel according to a predetermined reset signal;
    a reference side amplification transistor that amplifies a voltage of the floating diffusion layer in the reference pixel; and

a reference side selection transistor that outputs a signal corresponding to the voltage amplified by the reference side amplification transistor according to a predetermined selection signal, and
the read pixel is further provided with:

a read side reset transistor that initializes the floating diffusion layer in the read pixel according to a predetermined reset signal;
a read side amplification transistor that amplifies a voltage of the floating diffusion layer in the read pixel; and
a read side selection transistor that outputs a signal corresponding to the voltage amplified by the read side amplification transistor according to a predetermined selection signal.

3. The solid-state imaging device according to claim 2, further comprising:

a tail current source that supplies a current to a vertical current supply line commonly connected to the reference side amplification transistor and the read side amplification transistor, wherein
the predetermined signal line includes the vertical current supply line.

4. The solid-state imaging device according to claim 3, wherein
the potential control unit is provided with a switch that makes a potential of the vertical current supply line in the transfer period higher than the potential outside the transfer period.

5. The solid-state imaging device according to claim 3, wherein

the read side selection transistor outputs the signal through a vertical signal line, and
the potential control unit is provided with a switch that connects the vertical current supply line to the vertical signal line in the transfer period.

6. The solid-state imaging device according to claim 2, wherein

the predetermined signal line includes a vertical signal line that transmits the signal from the read side selection transistor, and
the potential control unit is provided with a switch that makes a potential of the vertical signal line in the transfer period higher than the potential outside the transfer period.

7. The solid-state imaging device according to claim 2, wherein

the predetermined signal line includes a potential fluctuation dedicated line, and
the potential control unit is provided with a driver that makes a potential of the potential fluctuation dedicated line in the transfer period higher than the potential outside the transfer period.

8. The solid-state imaging device according to claim 7, wherein
the potential fluctuation dedicated line is wired in a horizontal direction.

9. The solid-state imaging device according to claim 7, wherein
the potential fluctuation dedicated line is wired in a vertical direction.

10. The solid-state imaging device according to claim 2, wherein

the read pixel is further provided with a conversion efficiency control transistor that controls conversion efficiency of conversion of the charge into the voltage, and
the predetermined signal line includes a control line connected to a gate of the conversion efficiency control transistor.

11. The solid-state imaging device according to claim 2, wherein
an amplitude of the reset signal to the read side reset transistor and an amplitude of the reset signal to the reference side reset transistor are different from each other.

12. The solid-state imaging device according to claim 2, further comprising:

a driver that controls a potential of the transfer signal to any one of a predetermined low level, a middle level higher than the low level, and a high level higher than the middle level, wherein
the driver causes transition of the potential of the transfer signal from the high level to the middle level in the transfer period.

13. The solid-state imaging device according to claim 2, further comprising:
a current amount control unit that increases a current amount of a tail current supplied to the reference side amplification transistor and the read side amplification transistor over a predetermined period from when the transfer period ends.

14. The solid-state imaging device according to claim 1, wherein

a wiring layer is arranged between a microlens and the photoelectric conversion element on a predetermined semiconductor substrate, and
the transfer transistor is arranged in the wiring layer.

15. The solid-state imaging device according to claim 1, wherein

the photoelectric conversion element is arranged between a microlens and a wiring layer on a predetermined semiconductor substrate, and
the transfer transistor is arranged in the wiring layer.

16. A solid-state imaging device comprising:

a reference pixel provided with a predetermined wire; and
a read pixel provided with a wire having a shape different from a shape of the wire of the reference pixel.

17. The solid-state imaging device according to claim 16, wherein

in a horizontal direction perpendicular to a vertical signal line in a predetermined wiring layer,
a length of a portion where a wire connected to a reference side reset transistor in the reference pixel and a wire that connects a reference side amplification transistor to a reference side floating diffusion layer are closest is shorter than a length of a portion where a wire connected to a read side reset transistor in the read pixel and a wire that connects a read side amplification transistor to a read side floating diffusion layer are closest.

18. A solid-state imaging device comprising:

a read side photoelectric conversion element connected to a predetermined negative potential lower than a predetermined ground potential;
a read side transfer transistor that transfers a charge from the read side photoelectric conversion element to a read side floating diffusion layer;
a reference side photoelectric conversion element connected to the negative potential;
a reference side transfer transistor that transfers a charge from the reference side photoelectric conversion element to a reference side floating diffusion layer; and
a column read circuit unit provided with a tail current source connected to the ground potential that outputs, as a pixel signal, a signal obtained by amplifying a difference between a voltage of the read side floating diffusion layer and a voltage of the reference side floating diffusion layer.

19. The solid-state imaging device according to claim 18, wherein
the column read circuit unit is further provided with a negative potential generation unit that generates the negative potential.

20. The solid-state imaging device according to claim 19, wherein

the column read circuit unit is further provided with a switch that supplies either the negative potential or the ground potential to the read side photoelectric conversion element and the reference side photoelectric conversion element, and
the column read circuit unit amplifies the difference in a case where a predetermined differential mode is set, and outputs each of a signal obtained by amplifying he voltage of the read side floating diffusion layer and a signal obtained by amplifying the voltage of the reference side floating diffusion layer in a case where a predetermined source follower mode is set, and
the switch supplies the negative potential in a case where the differential mode is set, and supplies the ground potential in a case where the source follower mode is set.

21. The solid-state imaging device according to claim 20, further comprising:

a vertical drive unit that supplies a transfer signal to each of the read side transfer transistor and the reference side transfer transistor, wherein
the vertical drive unit supplies the transfer signal at a lower level than a level in the source follower mode in a case where the differential mode is set.

22. The solid-state imaging device according to claim 18, wherein

the column read circuit unit outputs a signal obtained by amplifying the difference through a vertical signal line, and
a shield line that covers the vertical signal line is connected to the ground potential.

23. An electronic device comprising:

a transfer transistor that transfers a charge from a photoelectric conversion element to a floating diffusion layer in a predetermined transfer period according to a transfer signal transmitted through a predetermined transfer line;
a potential control unit that makes a potential in the transfer period of a predetermined signal line capacitively coupled to the floating diffusion layer higher than the potential outside the transfer period; and
a signal processing unit that processes a pixel signal corresponding to a voltage of the floating diffusion layer.

24. A control method of a solid-state imaging device comprising:

a transfer procedure that transfers a charge from a photoelectric conversion element to a floating diffusion layer in a predetermined transfer period according to a transfer signal transmitted through a predetermined transfer line; and
a potential control procedure that makes a potential in the transfer period of a predetermined signal line capacitively coupled to the floating diffusion layer higher than the potential outside the transfer period.

FIG. 1

EP 3 941 033 A1

# FIG. 2

# FIG. 3

# FIG. 4

# FIG. 5

(11)

13

COLUMN READ
CIRCUIT UNIT

32

SW0,SW1,SW2

(16)

| UNIT READ CIRCUIT | UNIT READ CIRCUIT | UNIT READ CIRCUIT | UNIT READ CIRCUIT | ... |

300    300    300    300

$Vout_k$

(14)

# FIG. 6

# FIG. 7

# FIG. 8

START

RESET REFERENCE ROW
AND READ ROW — S901

CHARGE TRANSFER — S902

SIGNAL PROCESSING — S903

No — ARE ALL ROWS READ? — S904

Yes

END

# FIG. 9

# FIG. 10

# FIG. 11

# FIG. 12

# FIG. 13

# FIG. 14

# FIG. 15

# FIG. 16

120

121

Sub

124

FD

122

TRG

PD

123 RST

31$_{RR}$

L$_R$

VRDR$_k$

VSL

VSLR$_k$

SEL

AMP

125

126

VCOM$_k$

# FIG. 17

# FIG. 18

# FIG. 19

# FIG. 20

# FIG. 21

# FIG. 22

# FIG. 23

# FIG. 24

# FIG. 25

# FIG. 26

# FIG. 27

# FIG. 28

# FIG. 29

# FIG. 30

# FIG. 31

COLOR FILTER (R)  COLOR FILTER (G)  COLOR FILTER (B)

PD  PD  PD

120

10

501

502

# FIG. 32

# FIG. 33

## FIG. 34

# FIG. 35

COLOR FILTER (R)     COLOR FILTER (G)     COLOR FILTER (B)

120

10

502

501

VPL

N          N          N

· · ·

P WELL

# FIG. 36

# FIG. 37

# FIG. 38

|  | SF MODE | DIFFERENTIAL MODE |
|---|---|---|
| HIGH LEVEL OF TRANSFER SIGNAL | VTRGH (2. 7V) | VTRGH−VPL (2. 3V) |
| LOW LEVEL OF TRANSFER SIGNAL | VRL (−1. 2V) | VRL−VPL (−1. 6) |

## FIG. 39

# FIG. 40

# FIG. 41

# FIG. 42

# FIG. 43

# FIG. 44

<table>
<tr><td colspan="2" align="center">**INTERNATIONAL SEARCH REPORT**</td><td colspan="2">International application No.<br>PCT/JP2019/046497</td></tr>
</table>

A.   CLASSIFICATION OF SUBJECT MATTER
Int. Cl. H04N5/374(2011.01)i, H01L27/146(2006.01)i

According to International Patent Classification (IPC) or to both national classification and IPC

B.   FIELDS SEARCHED

Minimum documentation searched (classification system followed by classification symbols)
Int. Cl. H04N5/374, H01L27/146

Documentation searched other than minimum documentation to the extent that such documents are included in the fields searched
Published examined utility model applications of Japan     1922-1996
Published unexamined utility model applications of Japan   1971-2019
Registered utility model specifications of Japan           1996-2019
Published registered utility model applications of Japan   1994-2019

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 2018-182496 A (SONY SEMICONDUCTOR SOLUTIONS CORPORATION) 15 November 2018, paragraphs [0007]-[0014], [0113]-[0336], fig. 8-34 & WO 2018/190127 A1, paragraphs [0007]-[0014], [0113]-[0336], fig. 8-34 | 1-24 |
| Y | JP 2010-283859 A (FUJITSU SEMICONDUCTOR LTD.) 16 December 2010, paragraphs [0223]-[0269], fig. 36-39 (Family: none) | 1-15, 23, 24 |
| Y | WO 2019/026429 A1 (SONY SEMICONDUCTOR SOLUTIONS CORPORATION) 07 February 2019, fig. 19, 37 (Family: none) | 14, 15 |

☒   Further documents are listed in the continuation of Box C.          ☐   See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>16.12.2019 | Date of mailing of the international search report<br>24.12.2019 |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

**INTERNATIONAL SEARCH REPORT**

International application No.

PCT/JP2019/046497

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2014-75776 A (CANON INC.) 24 April 2014, fig. 7-10 & US 2014/0078354 A1, fig. 7-10 | 16, 17 |
| Y | JP 2015-159501 A (SONY CORP.) 03 September 2015, paragraph [0034] & US 2017/0053957 A1, paragraph [0056] | 18-22 |
| A | WO 2016/098590 A1 (SONY CORP.) 23 June 2016, fig. 1 & US 2017/0332026 A1, fig. 1 | 1-24 |
| A | JP 2018-182709 A (SONY SEMICONDUCTOR SOLUTIONS CORPORATION) 15 November 2018, fig. 9 & WO 2018/190166 A1, fig. 9 | 1-24 |
| A | JP 2002-152595 A (NIPPON HOSO KYOKAI) 24 May 2002, paragraphs [0027]-[0039] (Family: none) | 1-24 |

Form PCT/ISA/210 (continuation of second sheet) (January 2015)

**INTERNATIONAL SEARCH REPORT**

| International application No. |
|---|
| PCT/JP2019/046497 |

| Box No. II      Observations where certain claims were found unsearchable (Continuation of item 2 of first sheet) |
|---|

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III      Observations where unity of invention is lacking (Continuation of item 3 of first sheet) |
|---|

This International Searching Authority found multiple inventions in this international application, as follows:

  [see extra sheet]

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
  ☐ The additional search fees were accompanied by the applicant's protest and, where applicable, the payment of a protest fee.

  ☐ The additional search fees were accompanied by the applicant's protest but the applicable protest fee was not paid within the time limit specified in the invitation.

  ☐ No protest accompanied the payment of additional search fees.

Form PCT/ISA/210 (continuation of first sheet (2)) (January 2015)

**INTERNATIONAL SEARCH REPORT**

| International application No. |
| --- |
| PCT/JP2019/046497 |

(Continuation of Box No. III)

Document 1: A (SONY SEMICONDUCTOR SOLUTIONS CORPORATION) 15 November 2018, paragraphs [0007]-[0014], [0113]-[0336], fig. 8-34

The claims are classified as the three inventions below.

(Invention 1) Claims 1-15, 23, 24

Claims 1-15, 23, and 24 are classified as invention 1 due to having the special technical feature of "a potential control unit that, during the transfer period, controls the potential of a prescribed signal line that is capacitively coupled with the floating diffusion layer so as to be higher than the potential during the period that is not the transfer period."

(Invention 2) Claims 16, 17

Claims 16 and 17 share with claim 1 classified as invention 1, the feature of a "solid-state imaging device." However, this feature does not make a contribution over the prior art in light of the content disclosed in document 1 (refer particularly to paragraphs [0007]-[0014]), and thus this feature cannot be said to be a special technical feature. Furthermore, there are no other identical or corresponding special technical features between these inventions.

Moreover, claims 16 and 17 are not dependent claims of claim 1. Additionally, claims 16 and 17 are not substantially identical to or similarly closely related to any of the claims classified as invention 1.

Therefore, claims 16 and 17 cannot be classified as invention 1.

Claims 16 and 17 are classified as invention 2 due to having the special technical feature of a "readout pixel that is provided with wiring having a shape which is different from the wiring of the reference pixel."

Form PCT/ISA/210 (extra sheet) (January 2015)

| International application No. |
|---|
| PCT/JP2019/046497 |

(Invention 3) Claims 18-22

Claims 18-22 share with claim 1 classified as invention 1 and claim 16 classified as invention 2, the feature of a "solid-state imaging device." However, this feature does not make a contribution over the prior art in light of the content disclosed in document 1 (refer particularly to paragraphs [0007]-[0014]), and thus this feature cannot be said to be a special technical feature. Furthermore, there are no other identical or corresponding special technical features between these inventions.

Moreover, claims 18-22 are not dependent claims of claims 1 and 16. Additionally, claims 18-22 are not substantially identical to or similarly closely related to any of the claims classified as invention 1 or invention 2.

Therefore, claims 18-22 cannot be classified as either invention 1 or invention 2.

Form PCT/ISA/210 (extra sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018182496 A